# EUROPEAN PATENT APPLICATION

(11) **EP 4 826 586 A1**
(43) Date of publication of application: **21.10.2026**
(21) Application number: 25305543.8
(22) Date of filing: 15.04.2025
(51) Int. Cl.: G06F 30/10, G06F 30/17, G06F 30/27, G06N 20/00

(54) **MACHINE-LEARNING A CLASSIFICATION FUNCTION CONFIGURED FOR DETECTION OF MECHANICAL INTERFACES OF A CAD MODEL**

(71) Applicant: Dassault Systèmes, 78140 Vélizy-Villacoublay (FR)
(72) Inventor: PAGLIUGHI, Pierre, 78140 Vélizy-Villacoublay (FR); HEBRARD, Pascal, 78140 Vélizy-Villacoublay (FR); FEDRITZI, Benjamin, 78140 Vélizy-Villacoublay (FR); ZHANG, Zhenchen, 78140 Vélizy-Villacoublay (FR); BAYON DE NOYER, Camille, 78140 Vélizy-Villacoublay (FR)
(74) Representative: Bandpay & Greuter

(57) **Abstract**

The disclosure notably relates to a computer-implemented method for machine-learning a classification function configured for detection of mechanical interfaces of a CAD model representing a single mechanical part. The method comprises obtaining a training dataset comprising graphs, each graph representing a CAD model representing a single mechanical part. Each graph comprises one or more nodes representing a canonical surface of the respective CAD model. Each node comprises a label from the list: primary face, secondary face, tertiary face, maintain face, or no interface. Each graph further comprises one or more edges representing a connection between the canonical surfaces. The method further comprises training the classification function based on the dataset to classify, with a label of the label list, each node of a graph representing a CAD model representing a single mechanical part. This provides an improved solution for detecting mechanical interfaces.

## Description

### TECHNICAL FIELD

The disclosure relates to the field of computer programs and systems, and more specifically to methods, systems programs and machine-learnt functions for detection of mechanical interfaces of a CAD model.

### BACKGROUND

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

CAD models representing mechanical parts often comprise mechanical interfaces. The mechanical interface indicate zones of interaction, such as zones of contact, of the represented mechanical part with other possible mechanical parts. Correctly identifying the mechanical interfaces ensures that the mechanical part is correctly produced, with the appropriate tolerances. However, in the prior art, determining mechanical interfaces was a slow and manual process involving extensive amount of time from the user and prone to error.

Within this context, there is still a need for an improved method to determine the mechanical interfaces of a mechanical part.

### SUMMARY

It is therefore provided a computer-implemented method for machine-learning a classification function configured for detection of mechanical interfaces of a CAD model. The CAD model represents a single mechanical part. The learning method comprises obtaining a training dataset. The training dataset comprises training samples. Each training sample comprises a graph representing a CAD model representing a single mechanical part. The graph comprises one or more nodes. Each node represents a canonical surface of the CAD model. Each node comprises a label. The label is one within the label list: primary face of a mechanical interface, secondary face of a mechanical interface, tertiary face of a mechanical interface, maintain face of a mechanical interface, and no interface. The graph further comprises one or more edges. Each edge represents a connection between the canonical surfaces represented by the nodes connected by the edge. The learning method further comprises training the classification function based on the dataset to classify, with a label of the label list, each node of a graph representing a CAD model representing a single mechanical part. The method may be referred to as "the learning method" in the present disclosure.

The learning method may comprise one or more of the following:
- each of the graphs comprised in the training dataset comprises:
   - a node-vector for each node, the node-vector being a feature vector representing properties of the canonical surface represented by the node; and/or
   - an edge-vector for each edge, the edge-vector being a feature vector representing properties of the connection represented by the edge;
- the properties of the canonical surface represented by each node-vector comprise: surface type, area, radius, orientation, material, or a combination thereof;
- the properties of the connection represented by each edge-vector comprise: convexity, concavity, coplanarity, coaxiality, neighbor smooth, presence of a fillet, presence of a chamfer, presence of a connection other than a fillet or a chamfer, or a combination thereof;
- obtaining the training dataset comprises:
   - obtaining a first dataset comprising CAD models representing mechanical objects;
   - extracting from the first dataset a second dataset comprising CAD models representing single mechanical parts; and
   - for each CAD model in the second dataset determining a graph representing the CAD model;
- the determining of the graph representing the CAD model comprises:
   - determining the canonical surfaces of the CAD model, and generating a node for each determined canonical surface; and
   - determining the connections between couples of canonical surfaces of the CAD model, and generating an edge for each couple of connected canonical surfaces;
- each canonical surface is a portion of a plane, of a sphere, of a cone, of a torus, or of a cylinder;
- the classification function comprises a graph neural network;
- training the classification function comprises sampling nodes of each of the graphs in the training dataset so as to balance the no interface labels with the other labels; and/or
- the classification function further comprises a module configured to form mechanical interfaces based on the outputted labels by regrouping neighboring canonical surfaces corresponding to primary, secondary, tertiary, and maintain faces.

It is further provided a classification function obtainable according to the learning method, that is a computer-implemented classification function having the weights of a classification function learnt by the learning method. The provided classification function may for example have been learnt directly by the learning method, with its weights having been fixed by the learning step of the learning method.

It is further provided a method of use of the machine-learnt classification function. The method of use comprises obtaining a CAD model representing a single mechanical part. The method of use further comprises determining a graph representing the CAD model. The graph comprises one or more nodes. Each node represents a canonical surface of the CAD model. The graph further comprises one or more edges. Each edge represents a connection between the canonical surfaces represented by the nodes connected by the edge. The method of use further comprises applying the machine-learnt classification function to the graph. The method may be referred to as "the method of use" in the present disclosure.

It is further provided a computer program comprising instructions for performing the learning method and/or the method of use.

It is further provided a device comprising a data storage medium having recorded thereon the computer program and/or the classification function.

The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

### BRIEF DESCRIPTION OF THE DRAWINGS

Non-limiting examples will now be described in reference to the accompanying drawings, where:
- FIGs. 1 to 29 illustrate the method; and
- FIG. 30 shows an example of the system.

### DETAILED DESCRIPTION

It is proposed a computer-implemented method for machine-learning a classification function configured for detection of mechanical interfaces of a CAD model. The CAD model represents a single mechanical part. The learning method comprises obtaining a training dataset. The training dataset comprises training samples. Each training sample comprises a graph representing a CAD model representing a single mechanical part. The graph comprises one or more nodes. Each node represents a canonical surface of the CAD model. Each node comprises a label. The label is one within the label list: primary face of a mechanical interface, secondary face of a mechanical interface, tertiary face of a mechanical interface, maintain face of a mechanical interface, and no interface. The graph further comprises one or more edges. Each edge represents a connection (e.g., a connection type) between the canonical surfaces represented by the nodes connected by the edge. The learning method further comprises training the classification function based on the dataset to classify, with a label of the label list, each node of a graph representing a CAD model representing a single mechanical part.

As it will be explained in detail below, a mechanical interface of a CAD model representing a single mechanical part is a collection of canonical surfaces (e.g., portions) of the (e.g., of an outer surface) CAD model used to specify zones of possible interactions between the single mechanical part represented by the CAD model and other mechanical parts. That is, a mechanical interface may comprise (e.g., consist of) any possible zone of interaction between the mechanical part and any other collection of mechanical parts. Mechanical interfaces may specify areas to be produced with detailed tolerances.

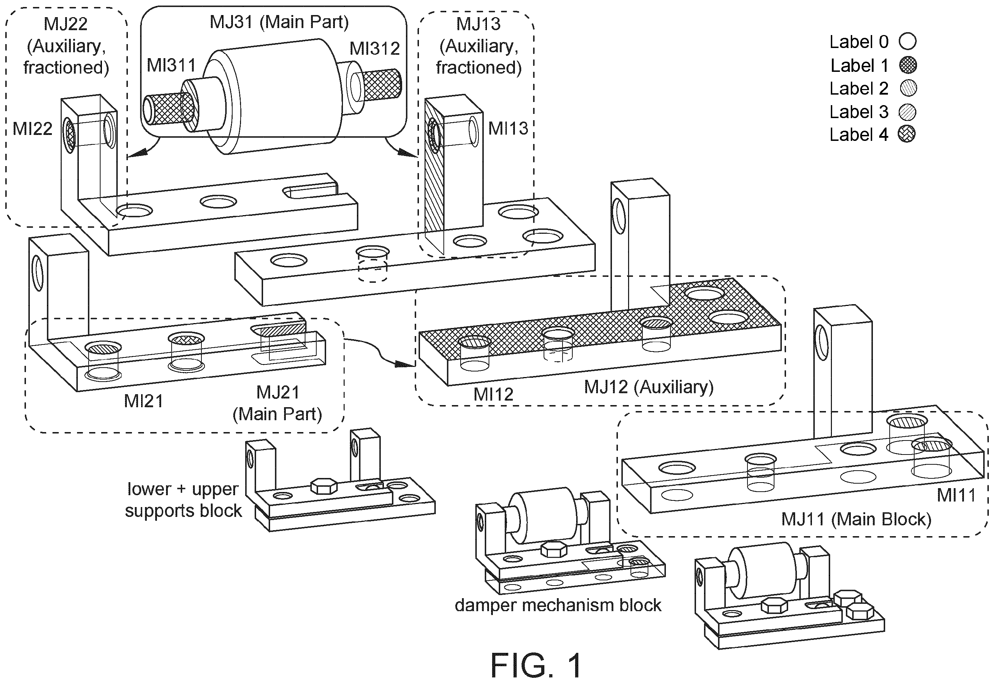

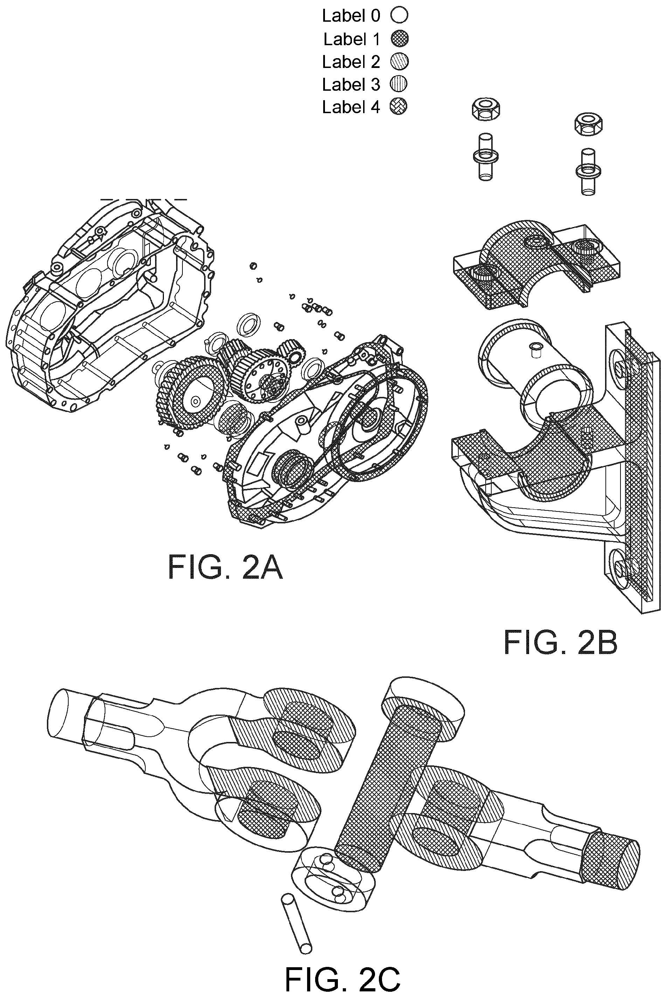

FIGs. 1, 2A, 2B, and 2C show examples of assemblies of mechanical parts, each assembly of mechanical parts comprising several mechanical parts, some of the mechanical parts comprising mechanical interfaces. Each of the canonical surfaces comprised in said mechanical interfaces is illustrated with a respective hatching corresponding to the classification (of the label list) in primary face of a mechanical interface, secondary face of a mechanical interface, tertiary face of a mechanical interface, maintain face of a mechanical interface, and no interface. Specifically, the hatching associated with the label "0" corresponds to canonical surfaces that are no interface. The hatching associated with the label "1" corresponds to canonical surfaces that are primary faces. The hatching associated with the label "2" corresponds to canonical surfaces that are secondary faces. The hatching associated with the label "3" corresponds to canonical surfaces that are tertiary faces. The hatching associated with the label "4" corresponds to canonical surfaces that are maintain faces.

In this disclosure, CAD models representing mechanical products (e.g., a single mechanical part or an assembly of mechanical parts) may be two- or three-dimensional, representing either the outer surface of the mechanical product (in the two-dimensional case) or the mechanical product itself (in the three-dimensional case). By the mention of "a portion of the CAD model" herein it is meant "a surface portion of the CAD model" (in the two-dimensional case) or "a portion of an outer surface of the CAD model" (in the three-dimensional case). Therefore, a portion of a CAD model as used herein consists always in a two-dimensional surface comprised in the CAD model. A portion of the CAD model may be connected (as a surface, in the standard mathematical sense) or not. Notably, any mechanical interface herein may consist of disjoint surfaces sharing a connection or connection type with each other, the connection (type) being one in a list, comprising, but not limited to, being adjacent, as it will be explained in detail below. Each CAD model (or the respective outer surface) can be partitioned into portions, each portion being a surface with boundary. For example, a CAD model may consist of a B-rep, the B-rep comprising vertices, edges, and faces. A portion of the CAD model may be, e.g., a portion of a face, a face, or a collection of faces of the B-rep (e.g., adjacent faces). Analogously, by the mention "zone" it is always meant a two-dimensional portion, corresponding to an outer surface of the mechanical part represented by the CAD model.

For any CAD model in the present disclosure, a canonical surface of the CAD model is a portion of the CAD model that corresponds to (e.g., with an affine isomorphism) a portion of one of the canonical surfaces. The canonical surfaces are the surfaces that may support a zone of contact between mechanical parts. The canonical surfaces may be, e.g., planes, spheres, cones, tori, or cylinders. Each CAD model (or outer surface of the CAD model) may be decomposed in one or more canonical surfaces and freeform surfaces, i.e., portions of the CAD model that are not one of the canonical surfaces. For example, a portion of the CAD model may be a chamfer or a fillet, such portions are not part of any canonical surface.

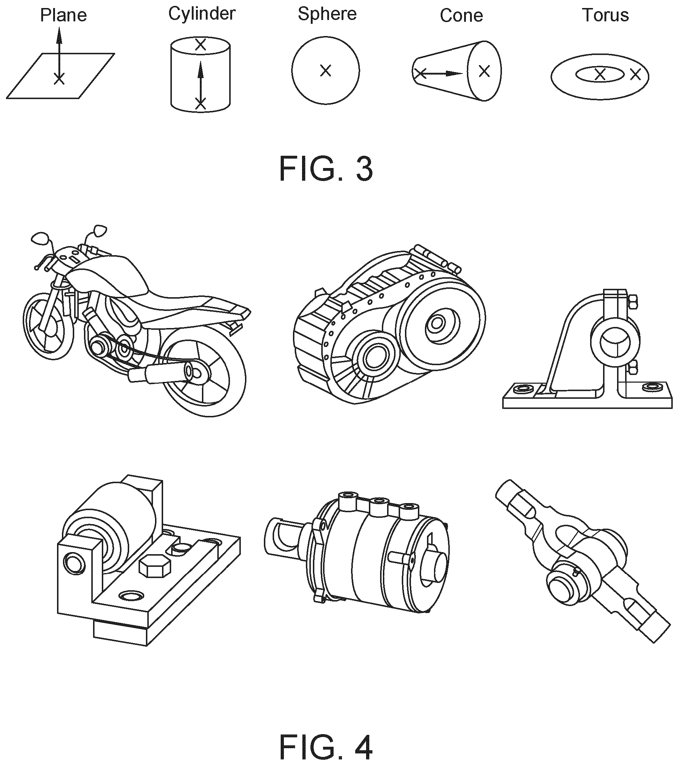

FIG. 3 illustrates the canonical surfaces.

Herein, a zone of interaction of a mechanical part with other mechanical parts may be a region of the mechanical part that has a functional role in the assembly of mechanical parts (composed by the mechanical part and the other mechanical parts). The functional role may be, e.g., to reduce the degree of freedom of the assembly of mechanical parts or maintaining the assembly of mechanical parts together. A zone of interaction may be a portion of the mechanical part where the mechanical part, e.g., comes into contact, or exerts mutual influence with the other mechanical parts. The zone of interaction may be used to facilitate movement, transmit forces, or perform functional operations within the assembly of mechanical parts.

Notably, a mechanical interface is a potential zone of interaction between the single mechanical part and other mechanical parts. On the other hand, a realized mechanical interface of a CAD model representing a single mechanical part within a CAD model representing an assembly of mechanical parts is a collection of canonical surfaces of the CAD model representing the single mechanical part that correspond to a zone of interaction between the single mechanical part and the other mechanical parts of the assembly of mechanical parts. Specifically, the canonical surfaces comprising the realized mechanical interface may each have a (e.g., different) functional role, such as reducing the degree of freedom of the assembly of mechanical parts or maintaining the assembly of mechanical parts together.

For example, the single mechanical part may be a bolt, and the assembly of mechanical parts may comprise a nut. In the mechanical assembly of parts, the nut may be tightened to the bolt. Therefore, the threads of the bolt may be in contact with the thread bore of the nut, and the contact reduces the degree of freedom of the assembly of mechanical parts, as the nut is thereby connected to the bolt. The surface of the CAD model representing the threads of the bolt is, therefore, comprised in a realized mechanical interface.

In the present disclosure, any realized mechanical interface of a CAD model representing a single mechanical part within a CAD model representing an assembly of mechanical parts may consist of a collection of canonical surfaces that have connections with each other (e.g., a connection type). Specifically, a connection between two canonical surfaces of the CAD model may correspond to the adjacency, the coplanarity, and/or the coaxiality of the two canonical surfaces. Additionally or alternatively, a connection between two canonical surfaces of the CAD model may correspond to a separation between the two canonical surfaces consisting of a fillet, a chamfer, and/or another non-canonical surface. In particular, the realized mechanical interface may consist of a collection of canonical surfaces that is connected with respect to the above defined connection. That is, given any pair of canonical surfaces comprised in the realized mechanical interface, there may be a way of passing from any canonical surface to any other, each time by passing from canonical surface to canonical surface having a connection between them, within the mechanical interface.

It is understood that the realized mechanical interfaces of a CAD model representing a single mechanical part within a CAD model representing the assembly of mechanical parts are in correspondence with the associated realized mechanical interfaces of the single mechanical part within the assembly of mechanical parts. One may speak therefore of a realized mechanical interface of either a CAD model or the associated single mechanical part and the two notions are in correspondence.

Each of the canonical surfaces comprised in a realized mechanical interface of a CAD model representing a single mechanical part within a CAD model representing an assembly of mechanical parts is classified in function of its role, as one of the list: primary face, secondary face, tertiary face, or maintain face of the realized mechanical interface. The classification may correspond to an associated function role of each of the canonical surfaces.

Each realized mechanical interface in the present disclosure comprises one or more primary faces. A primary face is a canonical surface comprised in the realized mechanical interface that constrains the most the position of the single mechanical part within the assembly of mechanical parts. Constrain the most may be with respect to the degrees of freedom of the assembly of mechanical parts, that is, a primary face may be a canonical surface of the realized mechanical interface that reduces the most degrees of freedom in the assembly of mechanical parts. The most herein may mean that the number of degrees of freedom reduced by the canonical surface may be higher than a coefficient times the maximal number of degrees of freedom reduced by any of the canonical surfaces comprised in the realized mechanical interface. The coefficient may be 1, so that the only primary faces are the canonical surfaces of the realized mechanical interface that reduce the maximum number of degrees of freedom. Alternatively, the coefficient may be any number lower than 1, such as 0.9 or 0.8.

Each realized mechanical interface in the present disclosure may comprise one or more secondary faces. A secondary face is a canonical surface comprised in the realized mechanical interface that is not a primary face and that constrains the most the position of the single mechanical part within the assembly of mechanical parts, aside from the primary faces (i.e., excluding or not considering the primary faces). Constrain the most may be with respect to the degrees of freedom of the assembly of mechanical parts, that is, a secondary face may be a canonical surface of the realized mechanical interface that is not a primary face and that reduces the most degrees of freedom in the assembly of mechanical parts, aside from the primary faces. The most herein may mean that the number of degrees of freedom reduced by the canonical surface may be higher than a coefficient times the maximal number of degrees of freedom reduced by any non-primary face of the realized mechanical interface. The coefficient may be 1, so that the only secondary faces are the canonical surfaces of the realized mechanical interface that reduce the maximum number of degrees of freedom, aside from the primary faces. Alternatively the coefficient may be any number lower than 1, such as 0.8 or 0.9.

Each realized mechanical interface in the present disclosure may comprise one or more tertiary faces. A tertiary face is a canonical surface of the realized mechanical interface that is neither a primary face nor a secondary face and that constrains the position of the single mechanical part within the assembly of mechanical parts. Constrain may be with respect to the degrees of freedom of the assembly of mechanical parts, that is, a tertiary face may be a canonical surface of the realized mechanical interface that is neither a primary face nor a secondary face and that reduces at least a degree of freedom in the assembly of mechanical parts.

Each realized mechanical interface in the present disclosure may comprise one or more maintain faces. A maintain face is a canonical surface of the realized mechanical interface that maintains the mechanical parts in the position set by the primary, secondary and tertiary surfaces within the assembly of mechanical parts.

Therefore, in the present disclosure, each realized mechanical interface of a CAD model representing a single mechanical part within a CAD model representing an assembly of mechanical parts may reduce a number *N* ≥ 1 of degrees of freedom of the assembly of mechanical parts. The number *N* may be written as a sum *N = N_{P} + N_{S} + N_{T}* corresponding to the primary, secondary, and tertiary faces.

The primary faces of the realized mechanical interface reduce (altogether) the number *N_{P}* ≥ 1 of degrees of freedom of the assembly of mechanical parts. The number *N_{P}* is the sum of one or more numbers *N*_{*P,*1}, *N*_{*P,*2}*, ..., N_{P,k_{P}}* each corresponding to the number of degrees of freedom reduced by respective primary faces, that is *ΣᵢN_{P,i} = N_{P}.* Each of the degrees of freedom reduced by each of the primary faces *N_{P,i}* may be bounded from below (e.g., they may all be the same and equal to the maximal number of degrees of freedom reduced by any face, or comprised in an interval as explained above).

Similarly, the secondary faces (if present) of the realized mechanical interface reduce (altogether) the number *N_{S}* ≥ 0 of degrees of freedom of the assembly of mechanical parts. The number *N_{S}* (if it is not 0) is the sum of one or more numbers *N*_{*S,*1}*, N*_{*S*,2}, *...*, *N_{S,k_{S}}* each corresponding to the number of degrees of freedom reduced by respective secondary faces, so that Σ*ᵢ N_{S,i}* = *N_{S}.* If the secondary faces are present (i.e., if *k_{S}* > 0), each of the degrees of freedom reduced by each of the secondary faces *N_{S,i}* may be bounded from below as explained above.

Similarly, the tertiary faces (if present) of the realized mechanical interface reduce (altogether) the number *N_{T}* ≥ 0 of degrees of freedom of the assembly of mechanical parts. The number *N_{T}* (if it is not 0) is the sum of one or more numbers *N*_{*T,*1}*, N_{T,2}, ..., N_{T,k_{T}}* each corresponding to the number of degrees of freedom reduced by respective tertiary faces, so that *Σᵢ N_{T,i} = N_{T}.* If the tertiary faces are present (i.e., if *k_{T} >* 0), each of the degrees of freedom reduced by each of the tertiary faces *N_{T,i}* is (strictly) positive as explained above.

In the present disclosure, each canonical surface of a CAD model representing a single mechanical part may be classified as one of the list: primary face, secondary face, tertiary face, maintain face, or no interface (without reference to any realized mechanical interface and/or any assembly of mechanical parts). The canonical surfaces that are classified as primary face, secondary face, tertiary face, or maintain face may also be denoted as interface faces, or canonical surfaces with interface.

In the present disclosure, each of the canonical surfaces of a CAD model representing a single mechanical part may be a primary/secondary/tertiary/maintain face if the canonical surface is a primary/secondary/tertiary/maintain face of some realized mechanical interface of the CAD model representing the single mechanical part within a CAD model representing an assembly of mechanical parts. Specifically, a canonical surface of a CAD model representing a single mechanical part may be a primary/secondary/tertiary/maintain face if:
- there exists a CAD model representing an assembly of mechanical parts comprising the CAD model representing the single mechanical part,
- there exists a realized mechanical interface of the CAD model representing the single mechanical part within the CAD model representing the assembly of mechanical parts, the mechanical interface comprising the canonical surface, and
- the canonical surface is a primary/secondary/tertiary/maintain face with respect to the mechanical interface.

A primary/secondary/tertiary/maintain face may also be referred to as a primary/secondary/tertiary/maintain face of a mechanical interface. A canonical surface of a CAD model is a no interface face if it is not a primary, secondary, tertiary, or maintain face, (that is, if a canonical surface is not an interface face).

It is understood that a CAD model representing a single mechanical part may be comprised in a plurality of CAD models representing each a respective assembly of mechanical parts, and that a canonical surface of the CAD model may be comprised in a plurality of realized mechanical interfaces. It may happen in this situation, the canonical surface may be, e.g., a primary face with respect to a realized mechanical interface and, e.g., a secondary face with respect to another realized mechanical interface. Indeed, the notion of primary/secondary/tertiary face is a relative notion to possible assemblies of mechanical parts potentially comprising the single mechanical part. This notion may not be expressed geometrically or intrinsically, and there may be different ways of formally defining the notion of primary, secondary, or tertiary faces. These different ways fundamentally agree on most of the concrete cases, but may disagree on some exceptional cases. The learning method and/or the method of use may be implemented (and do not depend on) using any of these formal definitions.

For example, a canonical surface may be classified as, e.g., a secondary face if it may be a secondary face but not a primary face of respective realized mechanical interfaces. In specifics, a canonical surface may be classified as a, e.g., secondary face if:
- the canonical surface is a secondary face of a realized mechanical interface of the CAD model representing the single mechanical part within a CAD model representing an assembly of mechanical parts; and
- the canonical surface is never a primary face of any realized mechanical interface of the CAD model representing the single mechanical part within any CAD model representing an assembly of mechanical parts.

Additionally or alternatively, a canonical surface may be labeled, e.g., a primary face if the canonical surface is a primary face of a highest proportion of realized mechanical interfaces comprising the canonical surface of the CAD model representing the single mechanical part, each realized mechanical interface being with respect to a respective CAD model representing an assembly of mechanical parts comprising the CAD model representing the single mechanical part.

The above examples may be easily generalized to give formal definitions of each of the above discussed labels. However, it is understood that as the learning method is for machine-learning a classification function and the classification function is trained on a dataset comprising several examples, each example comprising several canonical surfaces, the machine-learnt classification function is able to interpret the classification depending on the different formal definitions used by the different experts composing the dataset. Therefore, the classification function, after training, automatically interprets the formal definition used by the expert, without having a prior knowledge of any of these formal definitions. The machine-learnt classification function is able, therefore, to automatically detect the common ground of all these definitions.

A mechanical interface of a CAD model representing a single mechanical part is a connected component of canonical surfaces that are interface faces. In specific, a mechanical interface of a CAD model is a collection of canonical surfaces, each of which is a primary/secondary/tertiary/maintain face, that have connections (e.g., a path of canonical surfaces having mutual connections, as explained above) and such that all the other canonical surfaces of the CAD model with a connection to any of the canonical surfaces of the collection of canonical surfaces is a no interface face. As explained above, a connection (or, connection type) between two canonical surfaces of the CAD model may correspond to, e.g., the adjacency, the coplanarity, and/or the coaxiality of the two canonical surfaces. Additionally or alternatively, a connection (or, connection type) between two canonical surfaces of the CAD model may correspond to, e.g., a separation between the two canonical surfaces consisting of a fillet, a chamfer, and/or another non-canonical surface.

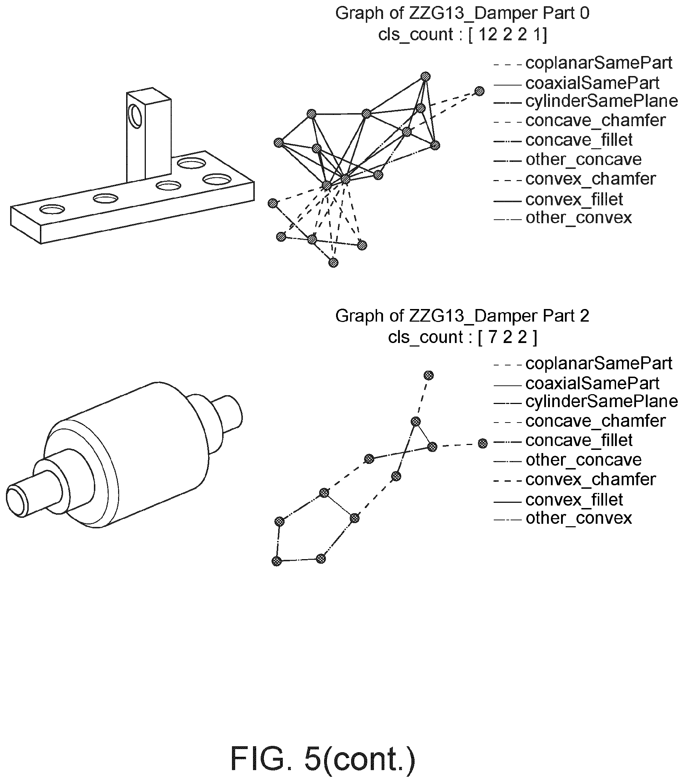

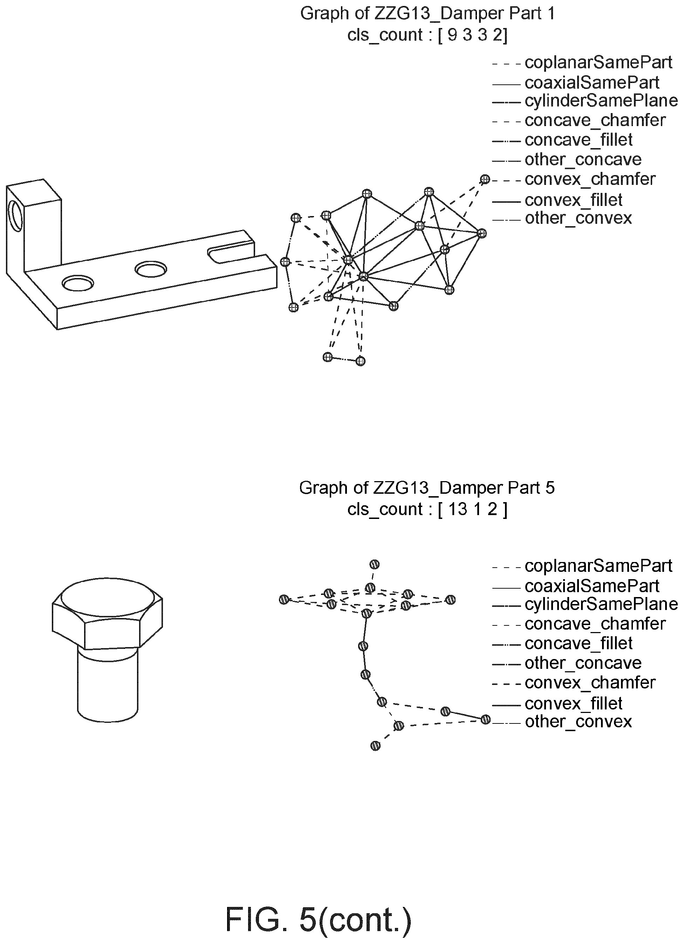

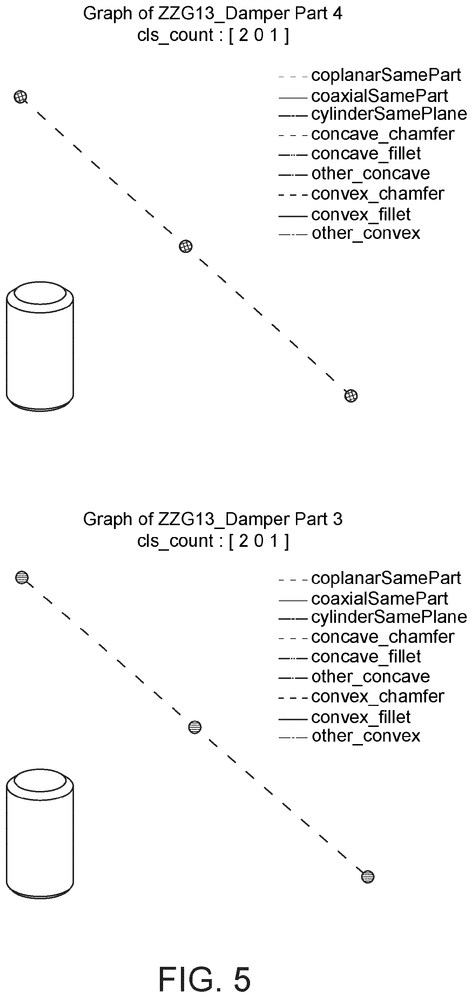

As it will be explained below, a CAD model representing a single mechanical part may be represented with a graph, whose nodes are each representing a canonical surface of the CAD model and whose edges are each representing a connection between respective canonical surfaces. Examples of CAD models and the respective graphs are given in FIG. 5. A mechanical interface may correspond to a connected component in the sub-graph consisting of all the nodes associated with the interface faces.

It is understood that the mechanical interfaces of a CAD model representing a single mechanical part are in correspondence with the associated mechanical interfaces of the single mechanical part. One may speak therefore of a mechanical interface of either a CAD model or the associated single mechanical part and the two notions are in correspondence.

It should be noted that a CAD model representing a single mechanical part may comprise a plurality of mechanical interfaces, each of which may be realized with respect to different CAD models representing assemblies of mechanical parts. Thus, the detection of a mechanical interface of a CAD model is a challenging task, as a user may have to be aware of all the possible mechanical assemblies comprising the mechanical part. It is, therefore, an extremely time-consuming task to manually detect each of the mechanical interfaces and/or label each canonical surface with the respective label. Moreover, this task is prone to error, as a user may forget some of the possible assemblies of mechanical parts, or not use the correct classification label for some of the canonical surfaces composing a mechanical interface. However, the detection of the mechanical interfaces may be required for the manufacturing process of the single mechanical part represented by a CAD model. In some cases, the detection of the mechanical interfaces may simplify the manufacturing process or may increase the longevity of the single mechanical part.

While manufacturing a single mechanical part represented by a CAD model it may be beneficial to accurately detect the mechanical interfaces. As the mechanical part may be used in an assembly of mechanical parts, the zone of interaction (e.g., a zone of contact) between the mechanical part and the other mechanical parts of the assembly of mechanical parts may be manufactured with higher precision to obtain that the mechanical parts composing the assembly of mechanical parts fit properly together (e.g., minimize the distance between the parts, minimize friction between the parts). Therefore, the zones of interaction (e.g., the zones of contact), represented by the mechanical interfaces, may be manufactured with a higher precision and more detailed tolerances than some other zones (e.g., canonical surfaces) of the mechanical part that are not supposed to have functional roles/be in contact with other mechanical parts. As manufacturing with higher precision may involve longer production time and/or more expensive materials/machinery, it may be beneficial to exactly detect which zones are no interface to speed up the production process. The design and precision of these zones of interaction may ensure proper alignment, minimize energy loss, and enhance the durability and performance of the mechanical assembly. Effective management of these interaction zones involves considerations of material compatibility, surface finish, lubrication, and tolerances to maintain optimal functionality under varying operational conditions. By meticulously defining the mechanical interfaces, mechanical product may achieve higher efficiency, reliability, and longevity.

While manufacturing a single mechanical part represented by a CAD model, it may be unclear to the manufacturer which use will be done with the mechanical part (e.g., in which mechanical assembly of parts will the mechanical part take place). It is therefore important to detect every possible use of the mechanical part, even those that were not initially intended. Therefore, it is important to consider each of the mechanical interfaces of the mechanical part.

The learning method is a method for machine-learning a classification function configured for detection of mechanical interfaces of a CAD model representing a single mechanical part. The learning method may therefore be used to obtain the machine-learnt classification function. It is further provided a method of use of the machine-learnt classification function. The method of use comprises obtaining a CAD model representing a single mechanical part. The method of use further comprises determining a graph representing the CAD model. The graph comprises one or more nodes. Each node represents a canonical surface of the CAD model. The graph further comprises one or more edges. Each edge represents a connection between the canonical surfaces represented by the nodes connected by the edge. The method of use further comprises applying the machine-learnt classification function to the graph.

The method of use may comprise machine-learning the classification function as in the learning method. It is also proposed a computer-implemented process that integrates the learning method and the method of use. The process comprises performing the method and then performing the method of use.

The machine-learnt classification function (of the method of use and learnt by the learning method) takes as input a graph representing a CAD model representing a single mechanical part and gives as output a classification of each of the nodes of the graph as one of the label list. As each node is in correspondence with a respective canonical surface of the CAD model, the machine-learnt classification function may give as output a classification of each of the canonical surfaces of the CAD model as one of the label list.

The classification function may further comprise a module configured to form mechanical interfaces based on the outputted labels by regrouping canonical surfaces corresponding to primary, secondary, tertiary, and maintain faces that have a connection, as defined above. In implementations, the module may process the subgraph of the graph representing the CAD model representing the single mechanical part, the subgraph consisting of all the interface nodes, that is, all the nodes that are labeled by the machine-learnt classification function as primary, secondary, tertiary, and maintain faces. The module may further comprise determining each of the connected components of said subgraph. The module may further comprise, for each of the connected components of said subgraph, form a mechanical interface consisting of the canonical surfaces represented by the nodes of the connected component of the subgraph. In other implementations, a mechanical interface may correspond to a subgraph that is not necessarily connected as the connections between the canonical surfaces composing the mechanical interface may not have been represented in the graph. In this case, other methods of regrouping may be implemented. Nevertheless, in implementations of the methods of the present disclosure, any mechanical interface involved in the method may correspond to a connected subgraph.

Therefore, the method of use may be used to take as input a CAD model representing a single mechanical part and give as output a classification of each of the canonical surfaces of the CAD model. Optionally, the method of use may give as output also the mechanical interfaces of the CAD model. Implementations of the method of use show that the output is obtained in real time (e.g., after a few seconds or fractions of a second after having provided the input). This is a huge improvement with respect to the manual method. Indeed, as described in detail above, the detection of mechanical interfaces is a complicated task that takes into account all possible assemblies of mechanical parts comprising the single mechanical part. The manual detection of mechanical interfaces may take more than one hour of time and, on the contrary, the method of use enables obtaining the classification for the canonical surfaces and/or the mechanical interfaces in real time (e.g., in less than a second). In particular, the machine-learnt classification function and the method of use greatly improve the ergonomics of the steps of detecting the classification of the canonical surfaces and/or the mechanical interfaces (and hence, more generally, designing CAD models representing single mechanical parts).

Moreover, the method of use may decrease the number of errors in the classification of the canonical surfaces and/or the detection of mechanical interfaces, compared to the manual method. Indeed, in the manual method the user may not see or imagine some of the possible assemblies of mechanical parts that may comprise a given single mechanical part. In addition, the user may not be certain of how exactly to classify each of the canonical surfaces composing a mechanical interface (e.g., in primary, secondary, tertiary, and maintain) as the definitions involved may be complex. Therefore, the method of use may be used to obtain a classification of the surfaces in the line of the examples provided by the experts, without the user having to understand each of the definitions involved in the classification.

The method of use may be included in a manufacturing process and/or the output of the method of use may directly be usable for manufacturing the product. For example, the method of use may include, after detecting the mechanical interfaces, storing the specifications of the CAD model representing a single mechanical part, for example in a file and/or as distributed CAD data on one or more storage and, optionally, converting them into manufacturing instructions (for example with a known CAD to CAM conversion process) for manufacturing a product modeled by said single mechanical part. The manufacturing instructions may, e.g., comprise different precision levels to be used for each of the canonical surfaces of the mechanical interface. The method may also automatically send the manufacturing instructions and/or the specifications (e.g., a stored file, or distributed specifications) to a manufacturing machinery, so that the manufacturing machinery, following the instructions, produces the mechanical part. The method may comprise the physical manufacturing or simply storing manufacturing instructions obtained from the specifications and output of the method and/or sending these instructions to the manufacturing process.

Therefore, the method of use constitutes a great improvement to manufacturing mechanical parts. Indeed, the method of use may ensure that all the mechanical interfaces of the single mechanical part to be manufactured are manufactured with the proper precision ensuring a smooth and efficient manufacturing process. The method of use may also comprise storing manufacturing instructions and/or manufacturing with a different precision each of the canonical surfaces depending on the classification of the canonical surface. For example, the method may comprise manufacturing with a higher precision the primary faces, and with a lower precision the maintain faces. This may further increase productivity, reduce the cost, and reduce errors.

The method of use (e.g., the obtaining a CAD model representing a single mechanical part) may also comprise acquiring an image of a single mechanical part and converting the acquired image into a CAD model representing the single mechanical part. Acquiring the image may, e.g., be from a distant or local source. For example, acquiring the image may comprise acquiring an image with a camera or with a 3D scan. Therefore, the method of use may be used to detect mechanical interfaces of a real world mechanical part, and more specifically from physical measurements thereof. This may, e.g., prove useful to manufacture copies of a mechanical part, ensuring that each canonical surface of the mechanical part is manufactured according to their function. Indeed, the image and/or 3D scan may not be accurate enough to detect the precision/tolerances used in the manufacturing of each of the canonical surfaces comprised in the mechanical part. Additionally or alternatively, detecting mechanical interfaces of a mechanical part may be useful to understand the possible uses of a mechanical part.

The learning method is a method of machine-learning, for learning a classification function (also called model). The learning method comprises obtaining a training dataset and training the classification function based on a training dataset. As is known *per se* from the field of machine-learning, the processing of an input by a model includes applying operations to the input, the operations being defined by data including weight values or parameters. Learning a model (e.g., a neural network or a GNN) thus includes determining values of the weights/parameters based on a dataset configured for such learning, such a dataset being possibly referred to as a learning dataset or a training dataset. For that, the dataset includes data pieces each forming a respective training sample or training example. The training samples/examples represent the diversity of the situations where the model is to be used after being learnt. Any training dataset herein may comprise a number of training samples/examples higher than 1000, 5000, or 10000. In the context of the present disclosure, by "learning a model based on a dataset", it is meant that the dataset is a learning/training dataset of the model, based on which the values of the weights/parameters are set. In the present disclosure, the training dataset is the obtained dataset of training examples, on which the model is learnt/trained. In implementations, the training dataset consists of tens of thousands examples each corresponding to a B-rep and an associated conditioning signal.

As is known *per se* from machine-learning, a neural network may be defined by its architecture, parameters, and hyperparameters. The architecture consists of layers, starting with the input layer whose neuron count may be determined by the dimensionality of the input data. This layer is followed by several hidden layers with a given number of neurons and activation functions. These layers and neurons define the network's depth and width, while the activation functions may introduce nonlinearity into the model. The output layer may have as many neurons as the variables in the output data. The interconnections between these layers define the topology of the neural network. The parameters of the neural network are the learnable weights and biases, which are determined in the training process. In contrast, the hyperparameters are pre-defined settings that are not learned from the training data. These encompasses the number of hidden layers, neurons per layer and much more. To train a neural network, at least two settings may be defined. First, a loss function, which is a metric that measures the error between the training data and the model's prediction, such as the mean square error (MSE) or the class-weighted cross entropy loss. Second, an optimizer, which modifies the model's weights and biases during the training process to minimize the loss function. Each optimizer has its own set of hyperparameters.

Specifically, the learning method comprises obtaining a training dataset comprising training samples, each training sample comprising a graph representing a CAD model representing a single mechanical part.

The obtaining of a training dataset may comprise retrieving (e.g., from local or remote memory) or receiving (e.g., from a remote system) the training dataset. Additionally or alternatively, the obtaining a training dataset may comprise generating at least part of the training dataset.

Obtaining/generating at least part of the training dataset may comprise obtaining a first dataset comprising CAD models representing mechanical objects (e.g., assemblies of mechanical parts, mechanical products). Obtaining/generating at least part of the training dataset may further comprise extracting from the first dataset a second dataset comprising CAD models representing single mechanical parts. Extracting from the first dataset may comprise retrieving from each CAD model representing a mechanical object each of the CAD models representing a single mechanical part. Obtaining/generating at least part of the training dataset may further comprise for each CAD model in the second dataset determining a graph representing the CAD model. A dataset comprising CAD models representing single mechanical parts may be called a CAD-dataset. The obtaining/generating at least part of the training dataset may also directly comprise obtaining a CAD-dataset and for each CAD model in CAD-dataset determining a graph representing the CAD model.

The obtaining of a first dataset and/or the CAD-dataset may comprise retrieving (e.g., from local or remote memory) or receiving (e.g., from a remote system) the first dataset and/or CAD-dataset.

Obtaining/generating at least part of the training dataset may be advantageous, as a plurality of CAD models representing single mechanical parts and/or assembly of mechanical parts may be available to the user.

FIG. 4 shows examples of mechanical assemblies of parts that may be used to obtain a CAD-dataset.

Each graph representing a CAD model representing a single mechanical part comprised in a training dataset will be referred to as a CAD-graph. A CAD-graph comprises one or more nodes and one or more edges. Each of the nodes represents a canonical surface of the CAD model and each edge represents a connection between the canonical surfaces represented by the nodes connected by the edge. As explained above, a connection between two canonical surfaces of the CAD model may correspond to, e.g., the adjacency, the coplanarity, and/or the coaxiality of the two canonical surfaces. Additionally or alternatively, a connection between two canonical surfaces of the CAD model may correspond to, e.g., a separation between the two canonical surfaces consisting of a fillet, a chamfer, and/or another non-canonical surface.

Notably, determining a CAD-graph from a CAD model representing a single mechanical part may comprise determining each of the canonical surfaces of the CAD model and all of the connections between the determined canonical surfaces. Determining the CAD-graph may further comprise defining a node for each determined canonical surface and an edge (between associated nodes) for each determined connection (between the respective associated canonical surfaces).

FIG. 5 shows different examples of CAD models representing single mechanical parts and the associated CAD-graphs.

In implementations, the CAD model may be a B-rep comprising a plurality of faces. In implementations, determining each of the canonical surfaces may comprise determining whether each of the faces of the B-rep is a portion of a canonical surface, that is a portion of a plane, a sphere, a cone, a torus, or a cylinder. In implementations, determining each of the canonical surfaces may further comprise joining one or more different faces that are portion of a same canonical surface. Therefore, in implementations, each of the detected canonical surfaces may consist of one or more faces of the B-rep defining the CAD model.

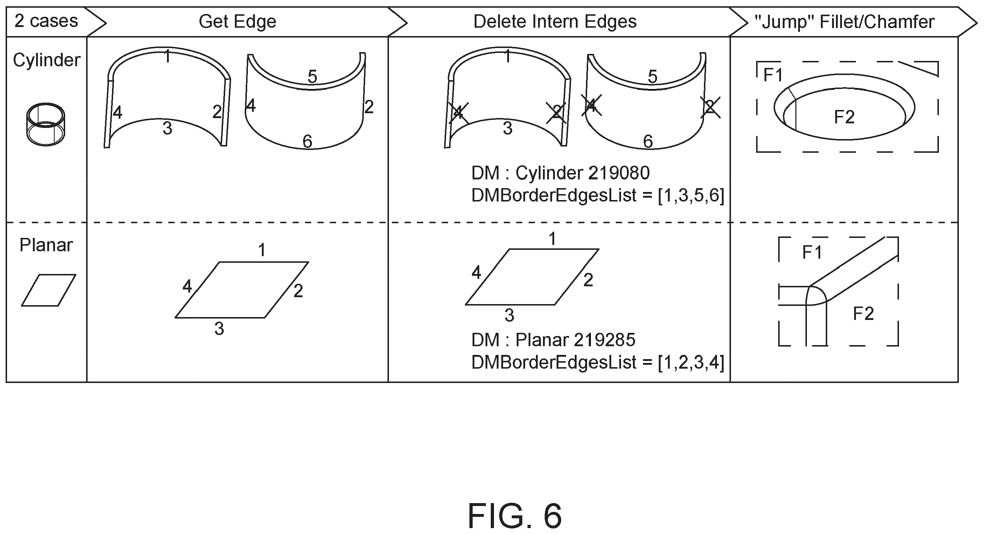

FIG. 6 illustrates an example of the above-described implementations. In the figure, a hollow cylinder is composed of two faces. The two faces are joined together to form a unique canonical surface that is a portion of a cylinder.

Each CAD-graph comprised in a training dataset further comprises a label for each node, the label is one within the label list: primary face of a mechanical interface, secondary face of a mechanical interface, tertiary face of a mechanical interface, maintain face of a mechanical interface, and no interface. Each label of each node corresponds to the respective classification of the canonical surface of the CAD model representing the single mechanical part associated with the node. That is, a node is labeled, e.g., primary face if and only if the canonical surface associated with the node, is a primary face.

Similarly, determining a CAD-graph from a CAD model representing a single mechanical part comprised in a CAD-dataset may comprise labelling each node with the classification label of the canonical surface represented by the node.

The obtaining of a training dataset may comprise obtaining and/or determining, for each CAD-graph comprised in the training dataset, a node-vector for each node of the CAD-graph and/or an edge-vector for each edge of the CAD-graph. In particular, the obtaining of a training dataset may comprise retrieving (e.g., from local or remote memory) or receiving (e.g., from a remote system) a node-vector for each node of each respective CAD-graph and/or an edge-vector for each edge of each respective CAD-graph. Additionally or alternatively, at least part of the training dataset may be determined from a CAD-dataset and the obtaining of the training dataset may further comprise determining, for each CAD model comprised in the CAD-dataset, a node-vector for each canonical surface (corresponding to a node) and/or an edge-vector for each connection between canonical surfaces (corresponding to an edge). Each of the node-vectors and/or edge vectors included in each of the CAD-graphs may be advantageous for training the classification function. Indeed, during training, the node-vectors and/or edge vectors may be used to better understand and predict the training samples.

In implementations, the method of use may further comprise obtaining and/or determining a node-vector for each canonical surface (and the corresponding node) and/or an edge-vector for each connection between canonical surfaces (and the corresponding edge) of the obtained CAD model.

A node-vector (that may be obtained and/or determined) may be a feature vector representing properties of the canonical surface represented by the node. In specific, a node-vector may be a vector comprising several entries, each entry corresponding to a respective property of the canonical surface represented by the node. For example, each node-vector may comprise an entry for a surface type (e.g., one within the list of the canonical surfaces, that is, plane, sphere, cone, torus, or cylinder), an area, parameters defining the surface type (e.g., radius if the surface type is a sphere), orientation, material, or a combination thereof.

An edge-vector (that may be obtained and/or determined) may be a feature vector representing properties of the connection represented by the edge. The feature vector may be a vector comprising several entries, each entry corresponding to a respective property of the connection between the canonical surfaces represented by the edge. For example, each property of the connection represented by each edge-vector representing the properties of a connection between two canonical surfaces comprise one or more of the following:
- convexity, that is, whether the local portion of the CAD model comprising the two canonical surfaces is convex;
- concavity, that is, whether the local portion of the CAD model comprising the two canonical surfaces is concave;
- coplanarity, that is, whether the two canonical surfaces are on a same plane;
- coaxiality, that is, whether the two canonical surfaces are portion of cylinders sharing the same axis;
- neighbor smooth, that is, the two canonical surfaces share a common edge in a same plane;
- presence of a fillet, that is, the two canonical surfaces are separated by a fillet;
- presence of a chamfer, that is, the two canonical surfaces are separated by a chamfer; and/or
- presence of a datum, that is, the two canonical surfaces are separated by a non-canonical set of surfaces (e.g., that may not support a mechanical interface) such as chamfrain, fillet, or curved surfaces.

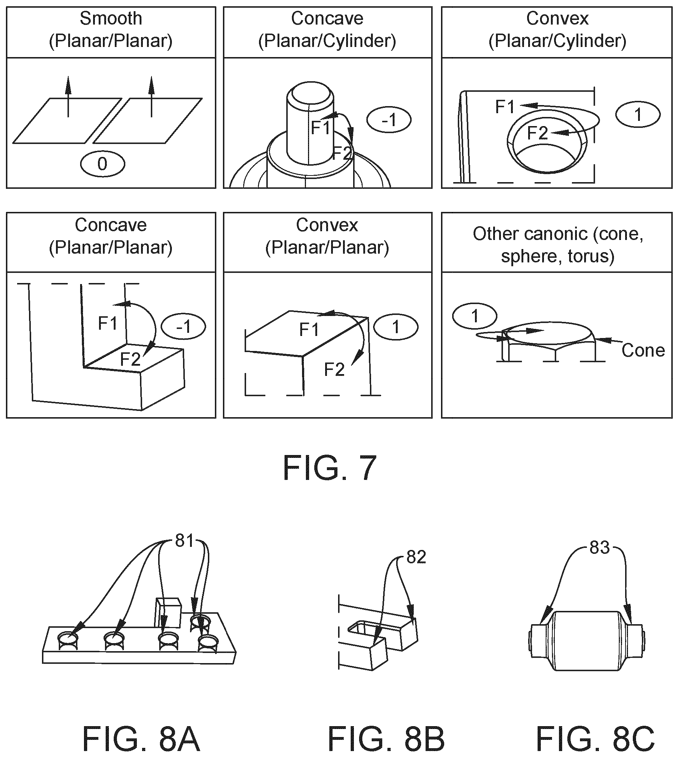

FIGs. 7-8 show examples of connections between canonical surfaces. The connections may be, e.g., smooth coplanar, concave, or convex.

FIG. 8A illustrates a mechanical part comprising five canonical surfaces that are portions of hollow cylinders 81. The five portions of hollow cylinders 81 are aligned on the same plane, that is, are coplanar. Therefore, the five portions of hollow cylinders 81 have pairwise connections to each other. The edge-vectors associated to the edges representing the connections may comprise the information that the connection is a coplanar connection between cylinders.

FIG. 8B illustrates a mechanical part with two canonical surfaces that are portion of planes 82. The two portions of planes 82 are coplanar. Therefore, the two portions of planes 82 have a connection. The edge-vector associated to the edge representing the connection may comprise the information that the connection is a coplanar connection between planes.

FIG. 8C illustrates a mechanical part with two canonical surfaces that are portion of cylinders 83. The two portions of cylinders 83 are coaxial. Therefore, the two portions of cylinders 83 have a connection. The edge-vector associated to the edge representing the connection may comprise the information that the connection is a coaxial connection between cylinders.

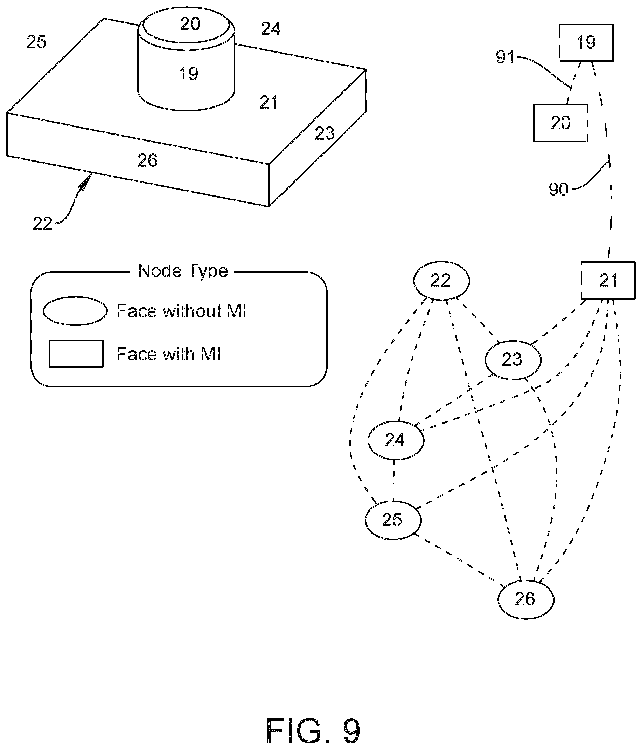

FIG. 9 shows a CAD model representing a single mechanical part and the associated graph. Each node of the graph is labeled as being part of a mechanical interface (without further specifying whether the node is associated with a primary, secondary, tertiary, or a maintain face). In particular, the canonical surfaces 19, 20, and 21 form a mechanical interface. In FIG. 5, each node may further comprise a node-vector. The node-vector of each of the nodes besides the node 19 may comprise the information that the surface type of the associated canonical surface is "plane", and the node-vector of the node 19 may comprise the information that the surface type of the associated canonical surface is "cylinder". Similarly, in FIG. 5, each edge may further comprise an edge-vector. The edge-vector of each of the edges besides the edge 90 may comprise the information that the connection between the associated canonical surfaces is "convex", and the edge-vector of the edge 90 may comprise the information that the connection between the associated canonical surfaces is "concave". The edge-vector of edge 91 may further comprise the information that the connection comprises a chamfer.

In implementations, determining a CAD-graph from a CAD model representing a single mechanical part, determining each of the node-vectors for each canonical surface (and the corresponding node), and/or determining each of the edge-vectors for each connection between canonical surfaces (and the corresponding edge) of a CAD model may comprise several different steps. For example, each of the determining may comprise several methods, each of which specialized in obtaining a single feature (e.g., an entry of a node/edge-vector). In implementations, determining a CAD-graph/each of the node vectors/each of the edge-vectors from a CAD model representing a single mechanical part may comprise one or more steps of extraction.

In implementations, generating each of the node-vectors from a CAD model may comprise extracting information related to mechanical interfaces (e.g., ID, type). In implementations, generating each of the node-vectors from a CAD model may comprise extracting the topology of the CAD model (e.g., ID, area, axis, material orientation, type of canonical surface). In implementations, generating each of the edge-vectors from a CAD model may comprise determining the connection mode (e.g., coaxial, coplanar, contact). In implementations, determining the connections between canonical surfaces of a CAD model may comprise detecting fillets and chamfers to study the neighborhoods between the canonical surfaces (e.g., portions of planes, cylinders, spheres, cones, tori).

In implementations, a step of extraction (comprised in the one or more steps of extraction) may comprise extraction of material meaning. Extraction of material meaning is a process that allows to determine certain characteristics of 3D objects, especially for cylinders. The extraction of material meaning enables the method to discern whether a cylinder is representing a hollow or solid part of the mechanical part. This may indicate whether the cylinder may be a screw, a gear, or another type of object. In implementations, extraction may comprise determining on which side of a canonical surface (e.g., a portion of a plane) the material is located.

In implementations, a step of extraction (comprised in the one or more steps of extraction) may comprise determining the normal and center of each face of the CAD model (e.g., of each canonical surface). The normal and center may determine an orientation relative to the object. The step of extraction may further comprise determining the orientation of each face in its "shell", the shell representing the outer envelope of the object. Herein, a "shell" may be a surface (e.g., a set of faces connected by edges) bounding a volume in the 3D space. A shell may be an inner shell or an outer shell.

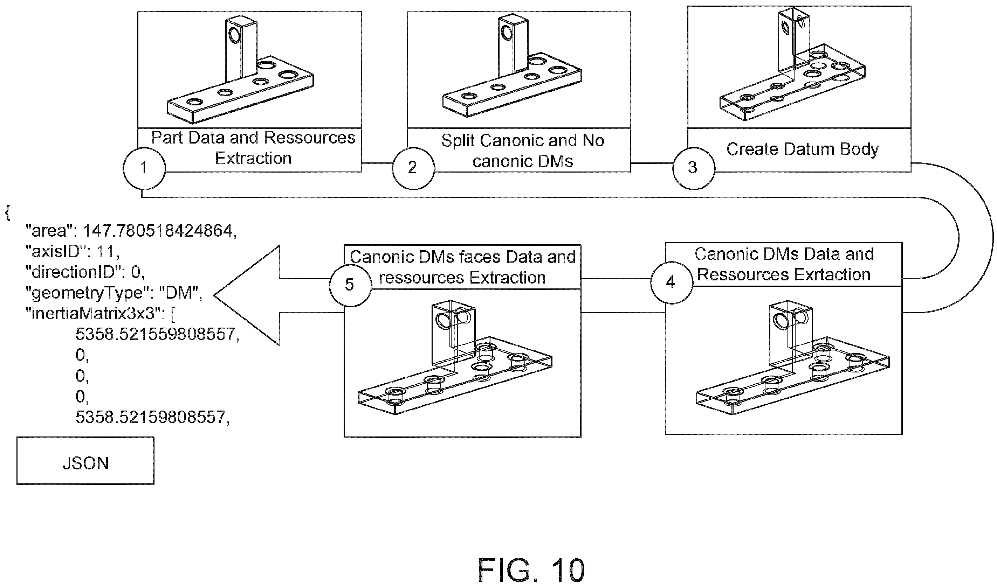

FIG. 10 illustrates an implementation of a step of extraction, comprising extracting data and resources, separating canonical surfaces and non-canonical surfaces, creating the datum body (e.g., the set of non-canonical surfaces), and extracting resources form the canonical surfaces.

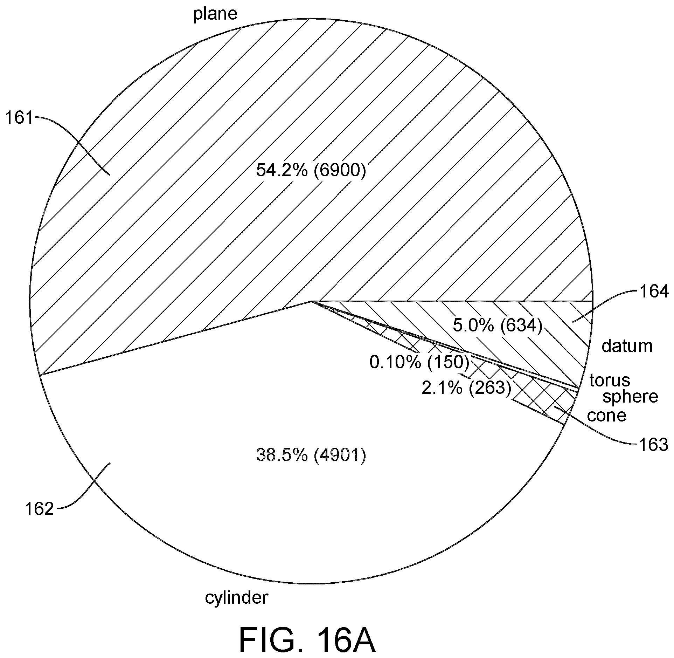

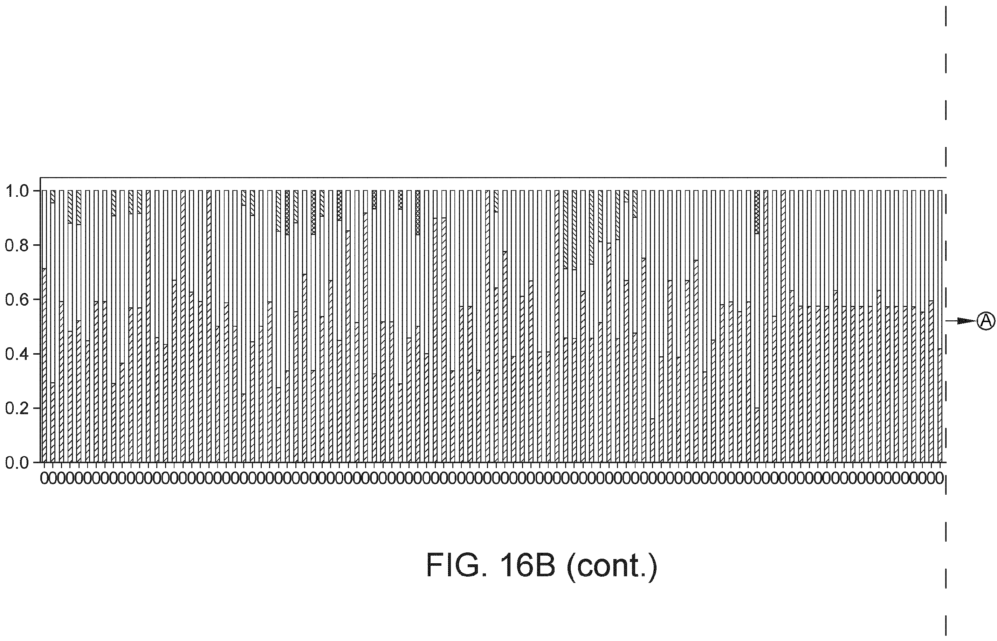

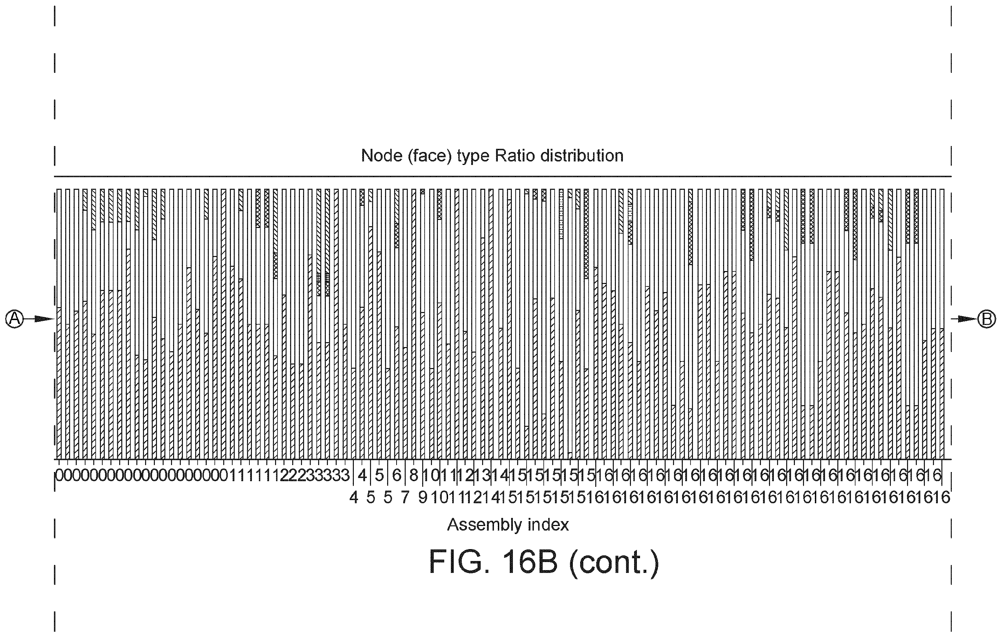

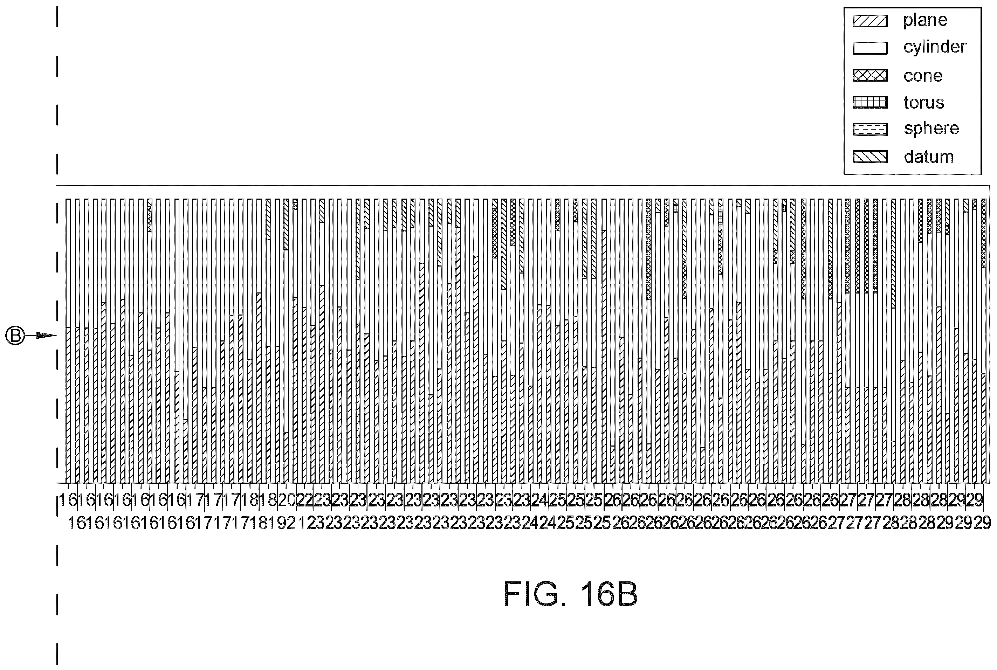

In implementations, the distribution of node types, edge types, and labels of the label list in a training dataset may not be homogenous. In implementations, it may be beneficial to have a diversified dataset (e.g., a dataset comprising many examples of different kinds) to increase the usability of the method. FIGs. 16-17 discussed below, show the distribution of surface types and labels in a dataset used for implementing the method.

In implementations, the learning method may comprise separating (e.g., partitioning) the training dataset into two (e.g., disjoint) parts, a first part that may be used to learn the classification function and a second part that may be used to test the classification function. The separating of the training dataset may comprise respecting the different proportions of the different features in the separating of the training dataset.

Notably, the method of use comprises obtaining a CAD model representing a single mechanical part and determining a CAD-graph from the CAD model. The determining of a CAD-graph may be implemented with the above-described steps of determining a CAD-graph to be included in the training dataset. Specifically determining a CAD-graph may comprise determining each of the canonical surfaces of the CAD model and all of the connections between the determined canonical surfaces. Determining the CAD-graph may further comprise defining a node for each determined canonical surface and an edge (between associated nodes) for each determined connection (between respective associated canonical surfaces). It is understood that whenever the training dataset includes some additional information attached to each of the CAD-graphs (such as node-vectors and/or edge-vectors), the method of use may comprise obtaining and/or determining at least part of the additional information, said additional information to be given as input to the classification function. The determining may be implemented as described above, e.g., with an extraction step.

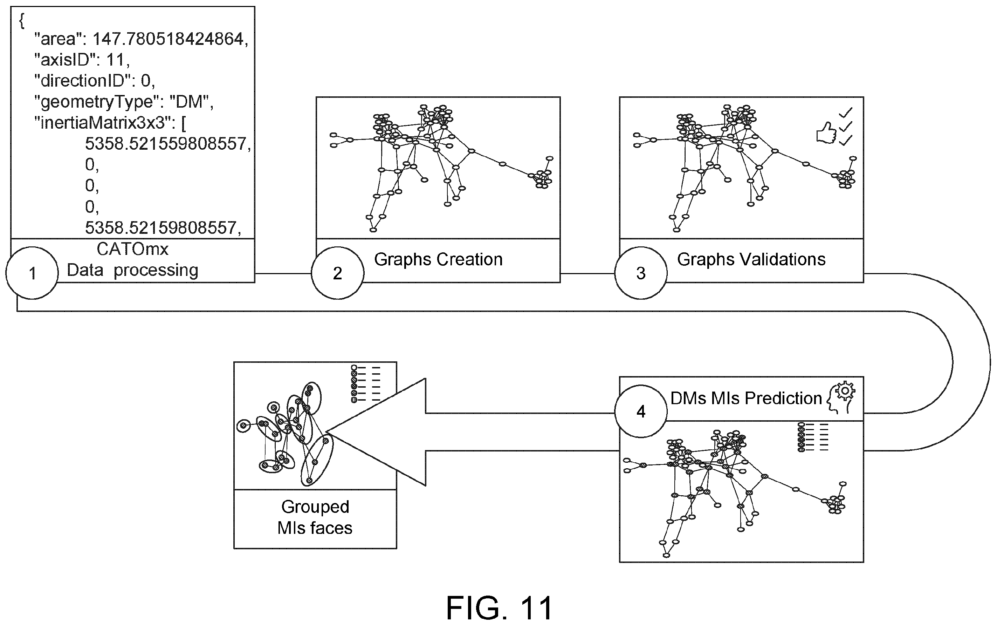

FIG. 11 illustrates a flowchart of the method of use, including creating and validating a CAD-graph from a CAD model representing a single mechanical part, using the classifying function to predict the labels of each of the node, and determining the mechanical interfaces from the labeled nodes.

The classification function may be based on (e.g., include) a graph neural network (GNN). A GNN is a type of neural network specifically designed to work with data structured as graphs. GNNs are powerful tools for analyzing data with complex interconnections, such as the connection types between the canonical surfaces of a CAD model representing a single mechanical part. GNNs perform neighborhood aggregation, updating node features by aggregating information from direct neighbors at each graph layer. This allows for information sharing as well as the capture of local context.

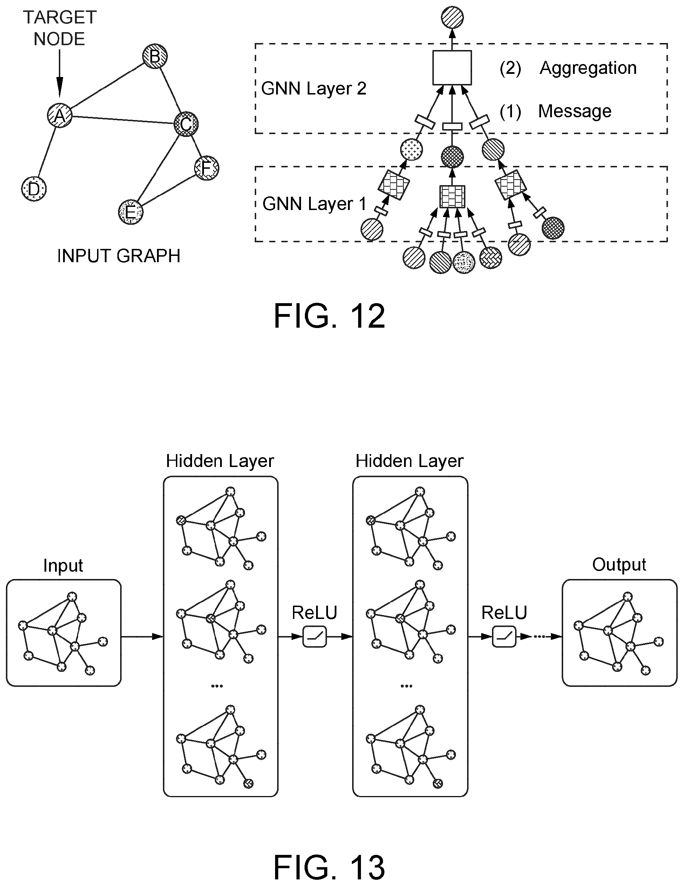

FIG. 12 illustrates the key mechanism of "message passing" of a GNN.

FIG. 13 illustrates an example of a model of a GNN that may be used in a classification function, comprising ReLU activation functions.

In implementations, the classification function may further include multi-layer perceptron (MLP) neural networks (e.g., a MLP before a GNN and a MLP after a GNN). The MLP may be used to augment the node features. Augmenting the node feature may enable the model to tackle more complicated situations by increasing the expressivity of the model.

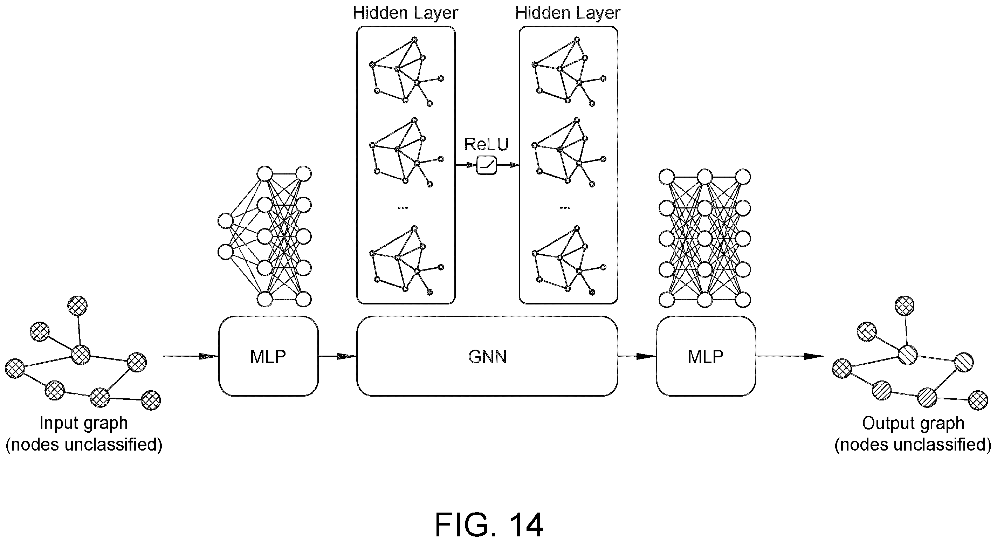

FIG. 14 illustrates an implementation of a classification function, consisting of a feed-forward architecture consisting of three main blocks: a MLP for feature augmentation, a GNN for node representation learning, and another MLP for classification.

The training of the classification function may include using a loss function. The loss function may be, e.g., the cross-entropy loss function. In implementations, the cross-entropy loss may be weighted based on different classes so as to compensate the imbalance of class distribution. Specifically, the samples from the minority class may be associated with a larger weight, while the samples from the majority class may receive smaller weights. In implementations, the loss function may be defined by the formula ${l}_{n} = - {w}_{{y}_{n}} log \frac{exp \left({x}_{n , {y}_{n}}\right)}{{\sum }_{c = 1}^{C} exp \left({x}_{n , c}\right)}$ where *n* is the sample, *xₙ* is the output vector of the classification function for the sample *n, yₙ* is the ground truth label of the sample *n, C* is the number of all classes, *x_{n,yₙ}* is the output of the classification function for the class *yₙ*, *x_{n,c}* is the output of the classification function for the class *c,* and *w_{yₙ}* is the weight associated with the class *yₙ*.

The training of the classification function may further comprise sampling nodes of each of the CAD-graphs in the training dataset so as to balance the no interface labels with the other labels. That is, at each batch and epoch during the training phase, the loss function may be computed with respect to all the nodes with an interface (i.e., primary/secondary/tertiary/maintain face of a mechanical interface) and a proportion of the nodes with no interface. The proportion may be chosen in such a way a same proportion of nodes are considered in the loss function with an interface and a no interface. The proportion of nodes with no interface may be chosen randomly among all the nodes with an interface. During training, a CAD-graph comprised in the training dataset may be used in several epochs and/or batches so that each node of the CAD-graph is used (e.g., considered by the loss function) during training. In particular, sampling may enable training on all nodes labeled as no interface over several epochs while ensuring a balanced class distribution in each epoch. Sampling may be beneficial, as using sampling during training may counterbalance the imbalance between the number of canonical surfaces that are interfaces with respect those that are not interfaces. An imbalance may cause the classification function to over-classify the canonical surfaces as no interface.

In implementations, the above-described steps of the learning method and method of use may be illustrated in a 3D assembly. For example, a CAD model representing a single mechanical part may be shown in a graphical interface including some of its features (e.g., contained in a node-vector and/or edge vector). Some of the features may comprise radius and/or material orientation. The user may interact with the graphical representation to execute the method (e.g., determining the classification of each of the canonical surfaces and/or determining the mechanical interfaces).

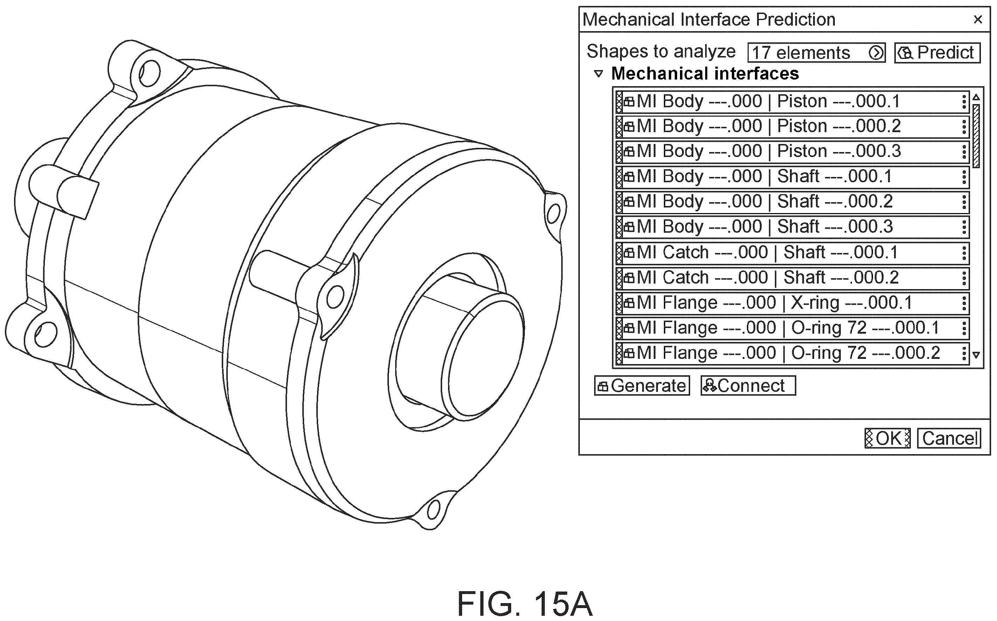

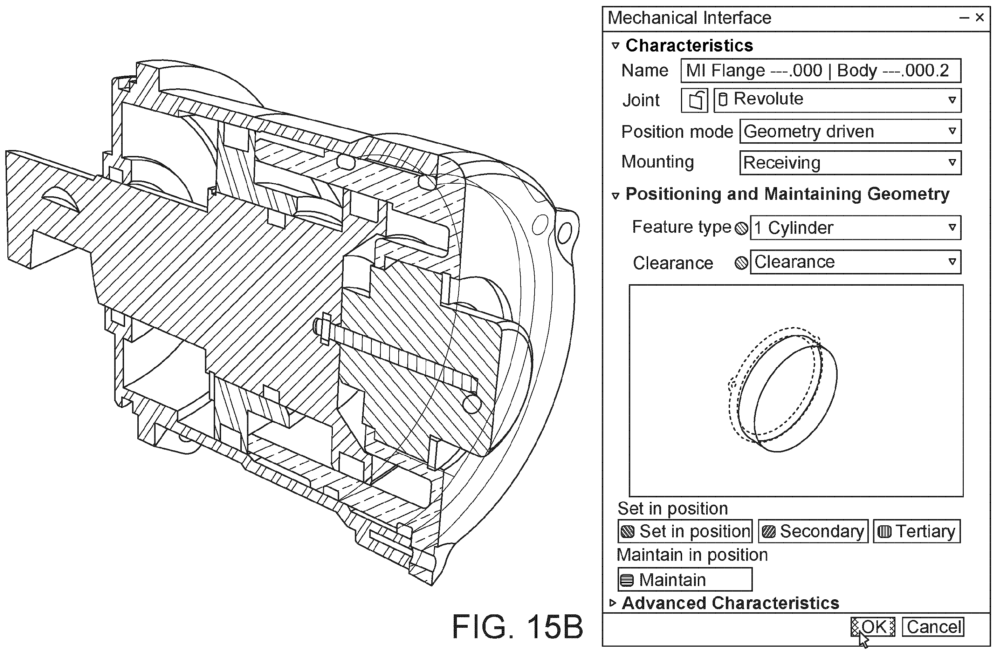

FIGs. 15A and 15B illustrate an implementation of the method, wherein a CAD model is shown in a graphical interface.

The learning method was implemented, and the classification function was tested on a dataset. The training dataset in the implementation consisted in mechanical parts coming from 30 assemblies of mechanical parts, such as the assemblies shown in FIG. 4, for a total of over 5800 mechanical interfaces.

FIGs. 16A and 16B show a distribution chart of the types of canonical surfaces included in the CAD models of the implemented dataset. The distribution chart of FIG. 16A indicates that 54.2% of the canonical surfaces are planes 161, 38.5% of the canonical surfaces are cylinders 162, 2.1% of the canonical surfaces are cones 163, and 5.0% of the canonical surfaces are datum 164.

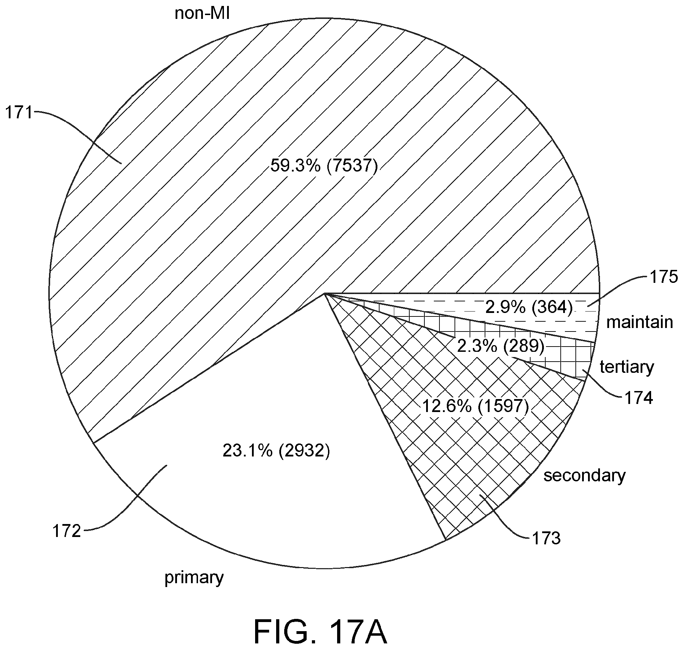

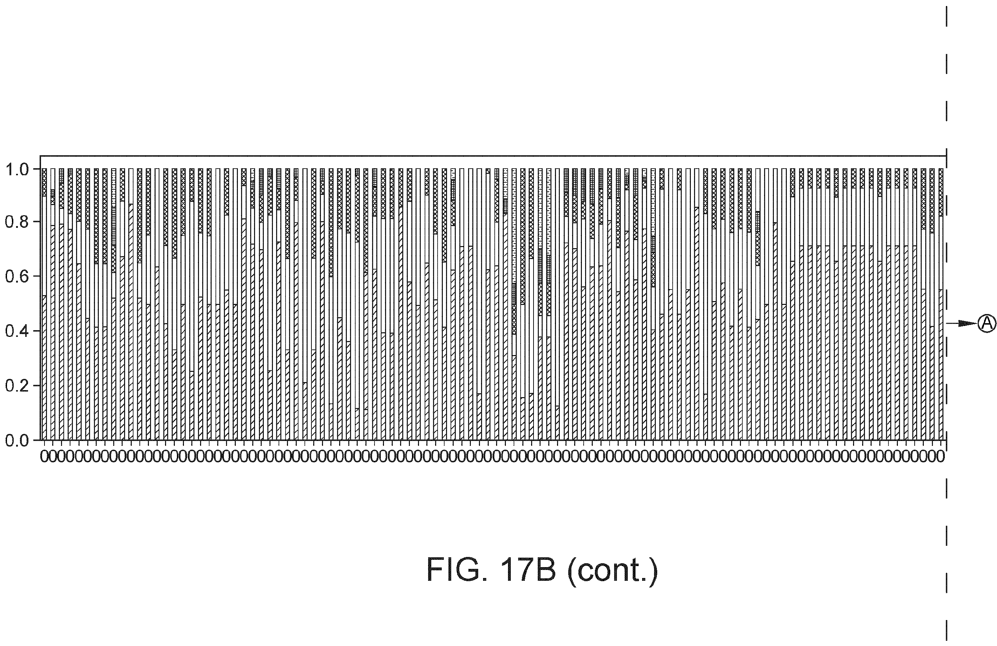

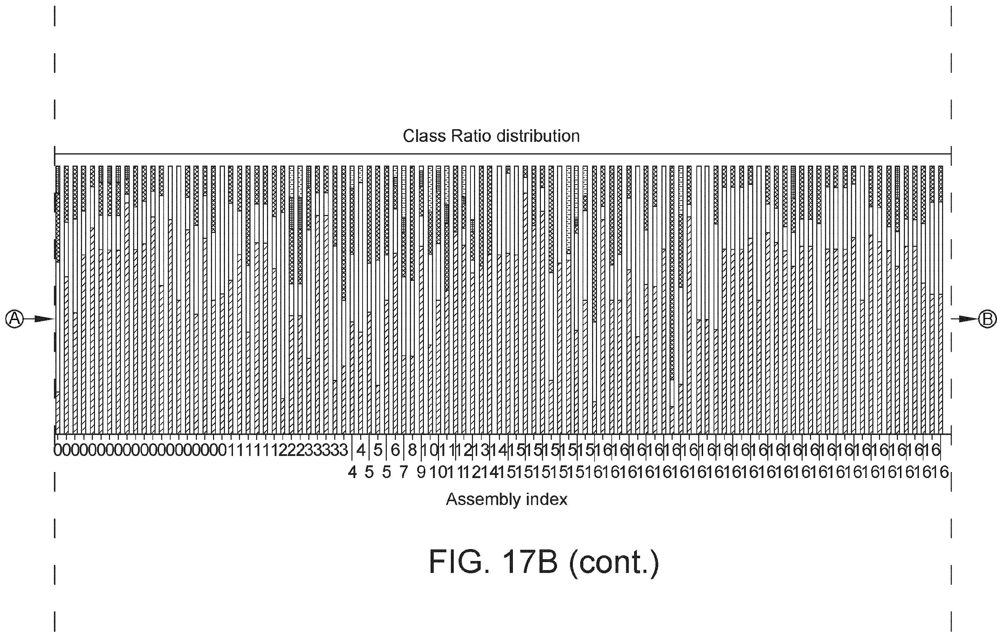

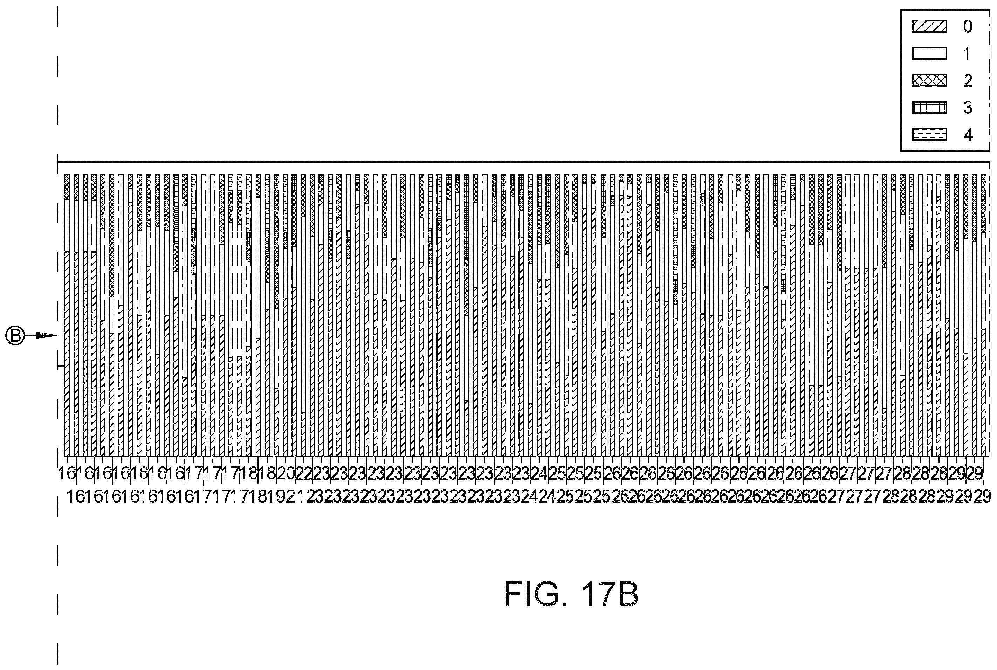

FIGs. 17A and 17B show a distribution chart of the label of the canonical surfaces included in the CAD models of the implemented dataset. The distribution chart of FIG. 17A indicates that 59.3% of the canonical surfaces are no interface 171, 23.1% of the canonical surfaces are primary faces 172, 12.6% of the canonical surfaces are secondary faces 173, 2.3% of the canonical surfaces are tertiary faces 174, and 2.9% of the canonical surfaces are maintain faces 175.

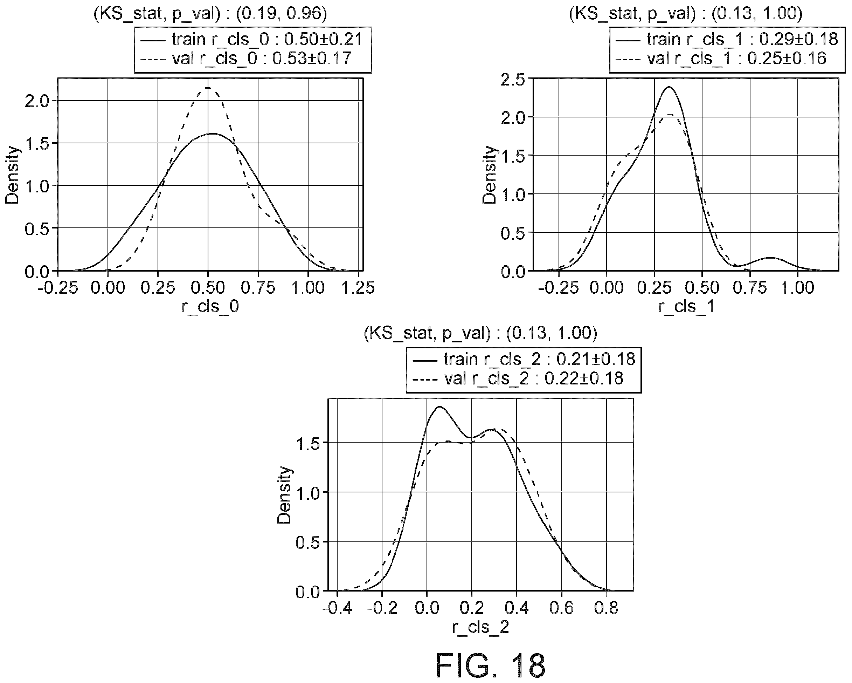

FIG. 18 shows a distribution of three classes in the training and testing dataset used in the implementation, showing that the proportion of the features are the same during training and testing.

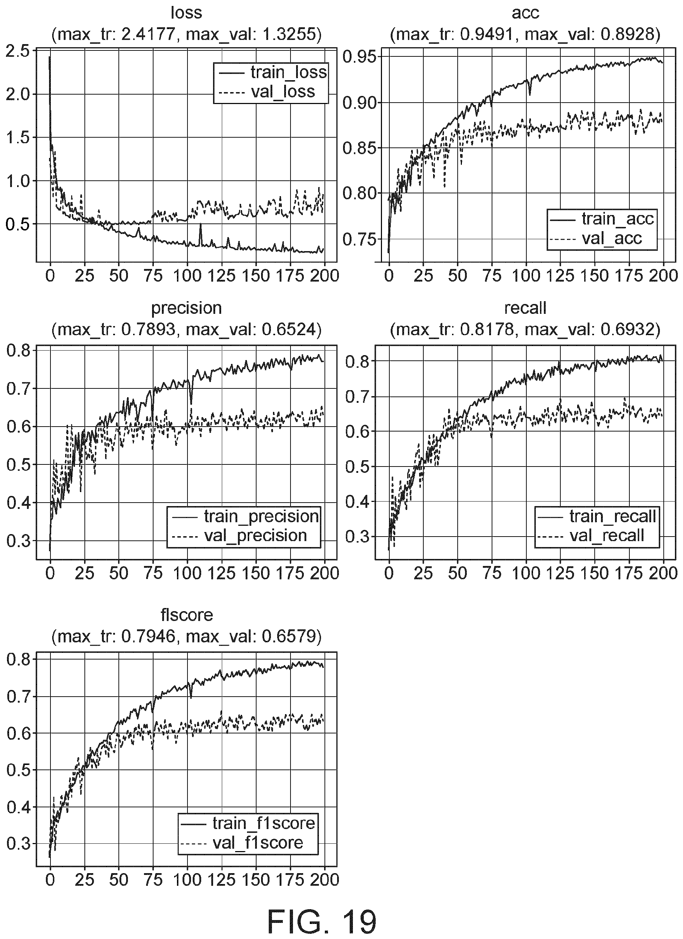

FIG. 19 shows the evolution of loss and metrics during the training of the classification function. In the implementation, the learning rate was 1e-3, the optimizer used was ADAM, and the batch size was 32.

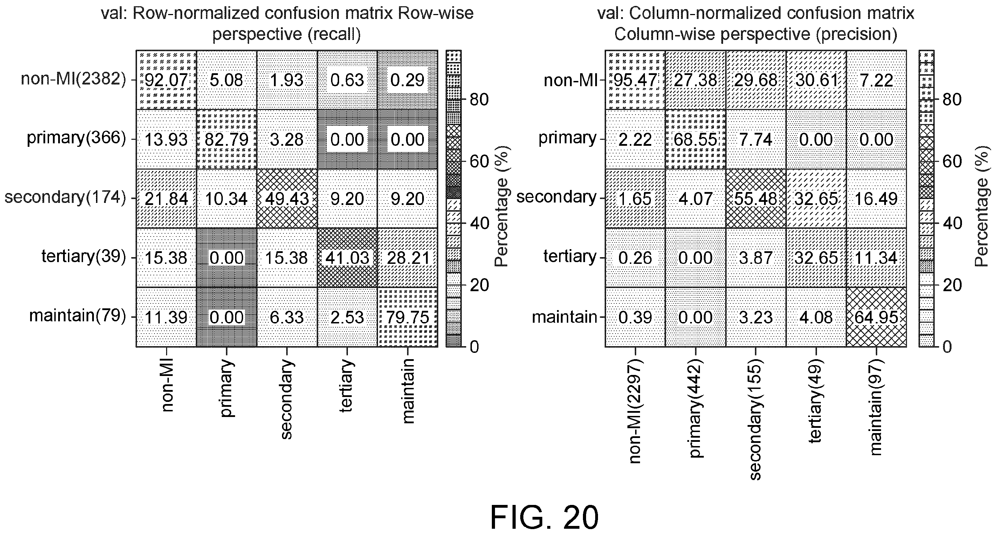

FIGs. 20-21 show the confusion matrix and the classification report of the result of the training of the classification function in the implementation.

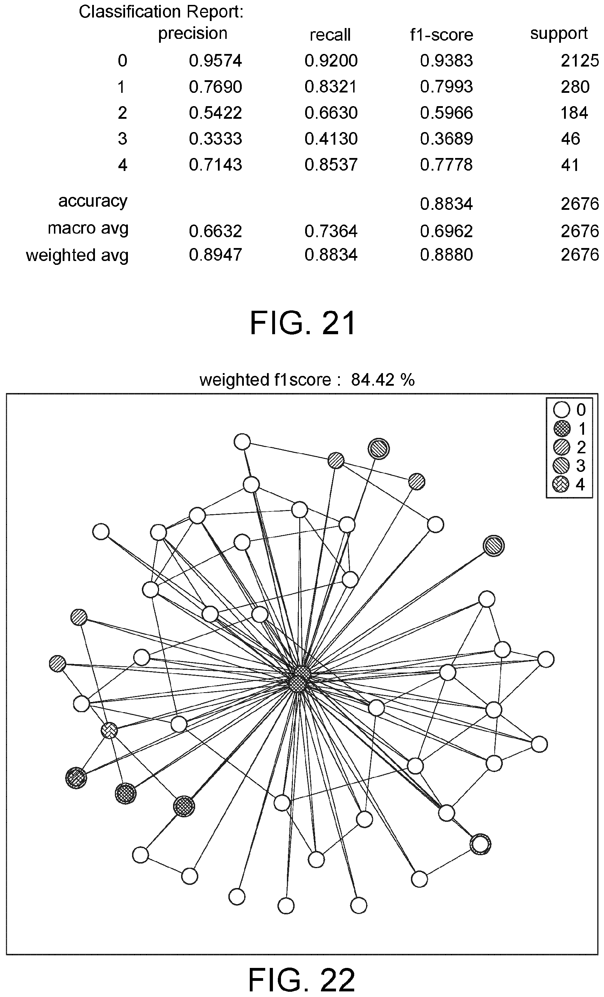

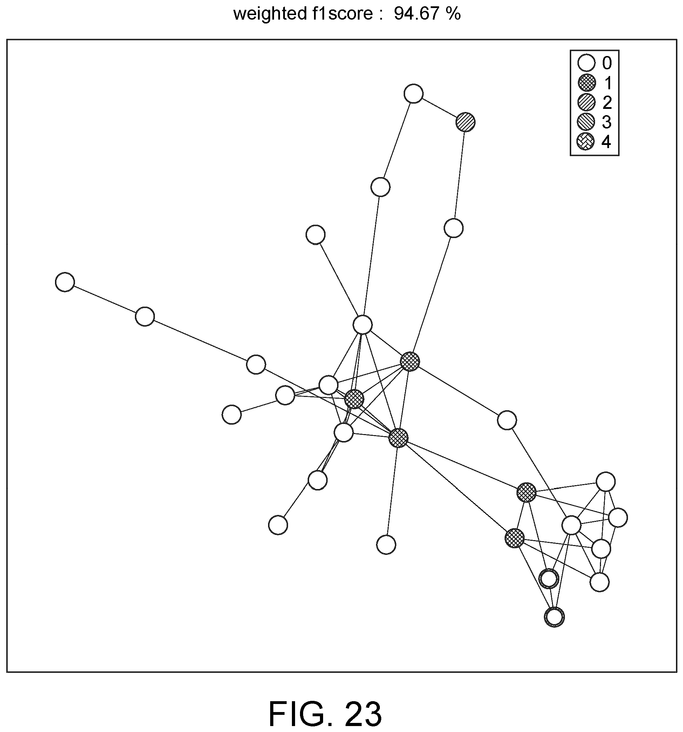

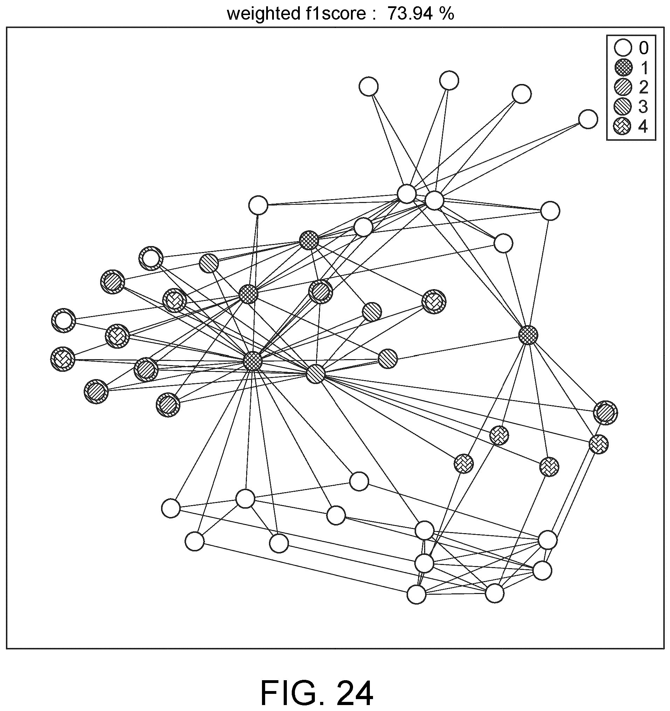

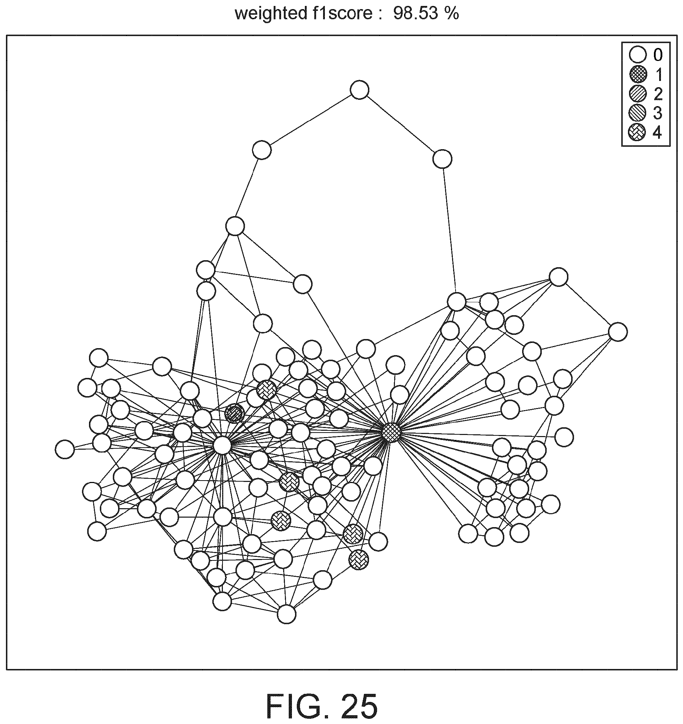

FIGs. 22-25 show the results of the implemented classification function applied to different CAD-graphs. As in FIGs. 1, 2A, 2B, and 2C, the hatching associated with the label "0" corresponds to canonical surfaces that are no interface. The hatching associated with the label "1" corresponds to canonical surfaces that are primary faces. The hatching associated with the label "2" corresponds to canonical surfaces that are secondary faces. The hatching associated with the label "3" corresponds to canonical surfaces that are tertiary faces. The hatching associated with the label "4" corresponds to canonical surfaces that are maintain faces. The nodes that have only one kind of hatching are the nodes correctly assessed by the implemented classification function (that is, the predicted classification corresponds to the ground truth, e.g., given by an expert). The nodes that have a border hatching different from the central hatching are the nodes that are wrongly classified by the classification function, with the central hatching being the ground truth (e.g., the labels given by experts) classification and the border hatching the inferred classification.

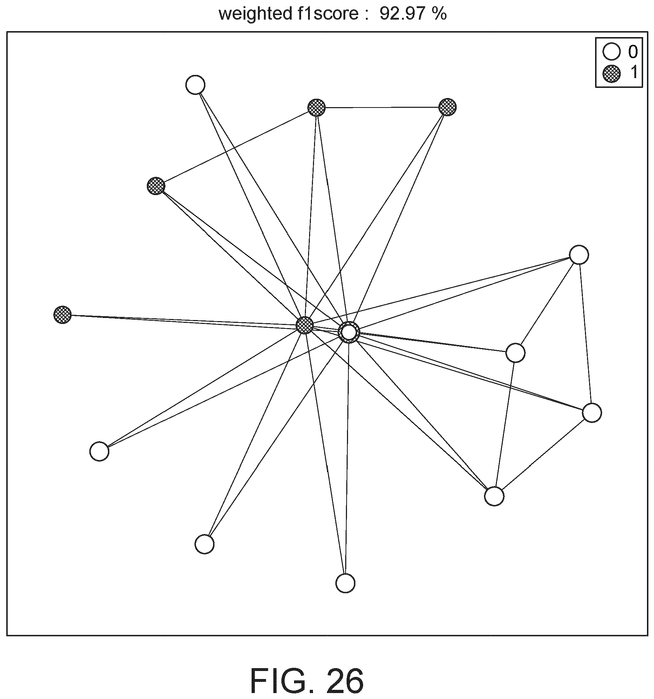

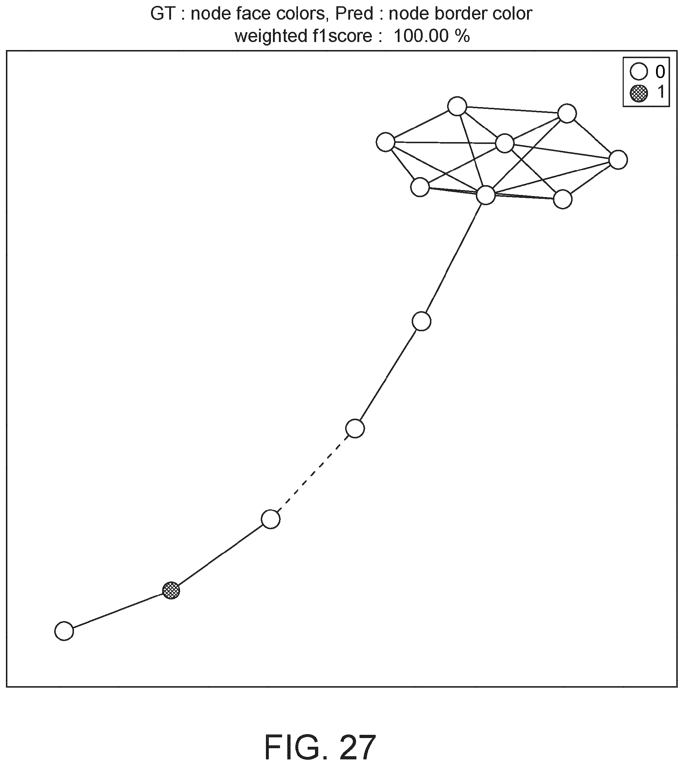

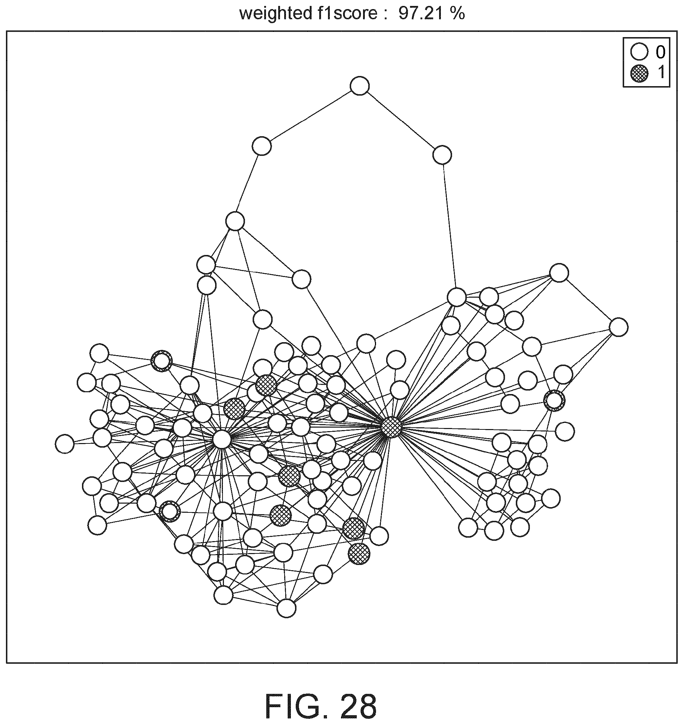

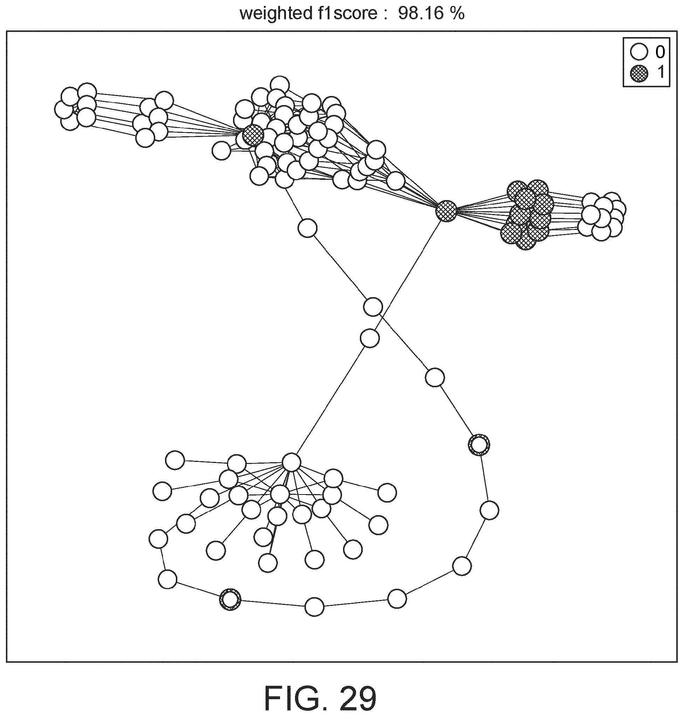

FIGs. 26-29 show the results of the implemented classification function applied to different CAD-graphs, only taking into account whether each node is an interface or a no interface node. In these figures, the hatching associated with the label "0" corresponds to canonical surfaces that are no interface. The hatching associated with the label "1" corresponds to canonical surfaces that are interface faces. As in FIGs. 22-25, the nodes that have only one kind of hatching are the nodes correctly assessed by the implemented classification function, whereas the nodes that have a border hatching different from the central hatching are the nodes that are wrongly classified by the classification function.

The methods and implementations presented in the present disclosure may be combined in any possible ways unless explicitly stated otherwise. In particular, any of the methods described herein may comprise any of the steps described in relation to any of the described methods and/or implementations of the present disclosure.

"Designing a manufacturing product/mechanical part/mechanical product" designates any action or series of actions which is at least a part of a process of elaborating a modeled object (3D or 2D) of the manufacturing product/mechanical part/mechanical product. The method may form such a process or may form at least a part of the process as described above.

The method thus generally manipulates modeled objects, such as CAD model outputted by the method. A modeled object is any object defined by data stored e.g. in the database. By extension, the expression "modeled object" designates the data itself. According to the type of the system, the modeled objects may be defined by different kinds of data. The system may indeed be any combination of a CAD system and a CAM system. In those different systems, modeled objects are defined by corresponding data. One may accordingly speak of CAD object, CAM object, CAD data, and CAM data. However, these systems are not exclusive one of the other, as a modeled object may be defined by data corresponding to any combination of these systems. A system may thus well be both a CAD and/or CAM system, as will be apparent from the definitions of such systems provided below.

By CAD solution (*e.g*. a CAD system or a CAD software), it is additionally meant any system, software or hardware, adapted at least for designing a modeled object on the basis of a graphical representation of the modeled object and/or on a structured representation thereof (*e.g*. a feature tree), such as CATIA. In this case, the data defining a modeled object comprise data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones. The typical size of a file representing a modeled object in a CAD system is in the range of one Megabyte per part. And a modeled object may typically be an assembly of thousands of parts. The specifications (also referred to as "CAD specifications") of a CAD model may be stored in a CAD file as explained above, but may also be stored as distributed CAD data on one or more storage, i.e. on a cloud environment.

In the context of CAD, a modeled object may typically be a 2D or 3D modeled object, e.g. representing a product such as a part or an assembly of parts, or possibly an assembly of products. The 2D or 3D modeled object may be a manufacturing product, *i.e*. a product to be manufactured. By "3D modeled object", it is meant any object which is modeled by data allowing its 3D representation. A 3D representation allows the viewing of the part from all angles. For example, a 3D modeled object, when 3D represented, may be handled and turned around any of its axes, or around any axis in the screen on which the representation is displayed. This notably excludes 2D icons, which are not 3D modeled. The display of a 3D representation facilitates design (i.e. increases the speed at which designers statistically accomplish their task). This speeds up the manufacturing process in the industry, as the design of the products is part of the manufacturing process.

The 3D modeled object may represent the geometry of a product to be manufactured in the real world subsequent to the completion of its virtual design with for instance a CAD/CAE software solution or CAD/CAE system, such as a (e.g. mechanical) part or assembly of parts (or equivalently an assembly of parts, as the assembly of parts may be seen as a part itself from the point of view of the method, or the method may be applied independently to each part of the assembly), or more generally any rigid body assembly (e.g. a mobile mechanism). A CAD/CAE software solution allows the design of products in various and unlimited industrial fields, including: aerospace, architecture, construction, consumer goods, high-tech devices, industrial equipment, transportation, marine, and/or offshore oil/gas production or transportation. The 3D modeled object designed by the method may thus represent an industrial product which may be any mechanical part, such as a part of a terrestrial vehicle (including e.g. car and light truck equipment, racing cars, motorcycles, truck and motor equipment, trucks and buses, trains), a part of an aerial vehicle (including e.g. airframe equipment, aerospace equipment, propulsion equipment, defense products, airline equipment, space equipment), a part of a naval vehicle (including e.g. navy equipment, commercial ships, offshore equipment, yachts and workboats, marine equipment), a general mechanical part (including e.g. industrial manufacturing machinery, heavy mobile machinery or equipment, installed equipment, industrial equipment product, fabricated metal product, tire manufacturing product), an electro-mechanical or electronic part (including e.g. consumer electronics, security and/or control and/or instrumentation products, computing and communication equipment, semiconductors, medical devices and equipment), a consumer good (including e.g. furniture, home and garden products, leisure goods, fashion products, hard goods retailers' products, soft goods retailers' products), a packaging (including e.g. food and beverage and tobacco, beauty and personal care, household product packaging).

A CAD system may be history-based. In this case, a modeled object is further defined by data comprising a history of geometrical features. A modeled object may indeed be designed by a physical person (i.e. the designer/user) using standard modeling features (e.g. extrude, revolute, cut, and/or round) and/or standard surfacing features (e.g. sweep, blend, loft, fill, deform, and/or smoothing). Many CAD systems supporting such modeling functions are history-based system. This means that the creation history of design features is typically saved through an acyclic data flow linking the said geometrical features together through input and output links. The history based modeling paradigm is well known since the beginning of the 80's. A modeled object is described by two persistent data representations: history and B-rep (i.e. boundary representation). The B-rep is the result of the computations defined in the history. The shape of the part displayed on the screen of the computer when the modeled object is represented is (e.g. a tessellation of) the B-rep. The history of the part is the design intent. Basically, the history gathers the information on the operations which the modeled object has undergone. The B-rep may be saved together with the history, to make it easier to display complex parts. The history may be saved together with the B-rep in order to allow design changes of the part according to the design intent.

By CAM solution, it is meant any solution, software of hardware, adapted for managing the manufacturing data of a product. The manufacturing data generally include data related to the product to manufacture, the manufacturing process and the required resources. A CAM solution is used to plan and optimize the whole manufacturing process of a product. For instance, it may provide the CAM users with information on the feasibility, the duration of a manufacturing process or the number of resources, such as specific robots, that may be used at a specific step of the manufacturing process; and thus allowing decision on management or required investment. CAM is a subsequent process after a CAD process and potential CAE process. For example, a CAM solution may provide the information regarding machining parameters, or molding parameters coherent with a provided extrusion feature in a CAD model. Such CAM solutions are provided by Dassault Systèmes under the trademarks CATIA, Solidworks or trademark DELMIA^{®}.

CAD and CAM solutions are therefore tightly related. Indeed, a CAD solution focuses on the design of a product or part and CAM solution focuses on how to make it. Designing a CAD model is a first step towards a computer-aided manufacturing. Indeed, CAD solutions provide key functionalities, such as feature based modeling and boundary representation (B-Rep), to reduce the risk of errors and the loss of precision during the manufacturing process handled with a CAM solution. Indeed, a CAD model is intended to be manufactured. Therefore, it is a virtual twin, also called digital twin, of an object to be manufactured with two objectives:
- checking the correct behavior of the object to be manufactured in a specific environment; and
- ensuring the manufacturability of the object to be manufactured.

The modeled object outputted/designed/taken as input by the method may be a 2D/3D discrete geometrical representation of a manufacturing product/mechanical product/mechanical part The discrete geometrical representation is a data structure which comprises a discrete set of pieces of data. Each piece of data may specify an element of the product/mechanical part, and be referred to as a discrete element. The discrete geometrical representation may be 3D or alternatively 2D. Yet alternatively, the discrete geometrical representation may be both 3D and 2D, *i.e.* may comprise a 3D portion which is a 3D discrete geometrical representation and a 2D portion which is a discrete geometrical representation, such as a hybrid 3D-2D meshing (*e.g*. for modeling a product comprising both thin parts, modeled with the 2D portions, and thick parts, modeled with the 3D portions). The discrete geometrical representation may in examples comprise a number of such pieces of data higher than 100, 1000, or 10000.

The modeled object outputted/designed/processed/taken as input by the method may be a CAD model, for example comprising or consisting in a feature tree and/or a B-rep. Such a model may stem from a CAE model and may results from a CAE to CAD conversion process, that the method may for example comprise at an initial stage.

The CAD model may be feature-based (*e.g*. it may comprise a feature tree, and optionally a corresponding B-rep obtained by executing the feature tree). A feature-based 3D model allows (*e.g*. during the determination of a manufacturing file or CAM file or CAM specifications stored as distributed data as discussed hereinafter) the detection and an automatic resolution of a geometry error in a CAD model such as a clash that will affect the manufacturing process. A clash is an interpenetration between two parts of a 3D model for example due to their relative motion. Furthermore, this clash may sometimes only be detected via a finite element analysis based on the CAD feature-based model. Therefore, a resolution of a clash can be performed with or automatically by the CAD solution by iteratively modifying the parameters of the features and doing a finite element analysis.

As another example, a feature-based 3D model allows (*e.g*. during the determination of a manufacturing file or CAM file or CAM specification stored as distributed data as discussed hereinafter) an automatic creation of a toolpath for a machine via a computer numerical control (CNC). With CNC, each object to be manufactured gets a custom computer program, stored in and executed by the machine control unit, a microcomputer attached to the machine. The program contains the instructions and parameters the machine tool will follow. Mills, lathes, routers, grinders and lasers are examples of common machine tools whose operations can be automated with CNC.

A key characteristic of a CAD model is that it may be designed exactly and unambiguously by chaining a small number of high-level parameterized design operations (including for example, but not limited to, sketch, extrusion, chamfer) and edited by modifying its high-level parameters. That this is a key distinction with the polyhedral representations such as a triangular surface mesh which may represent any 3D shape but do not provide modification or parameterization capabilities required in an industrial design context.

As CAD model is a parameterized model of a part/product, it is lighter in terms of memory footprint than other models such as a CAE model. Indeed, instead of storing a collection of discrete geometrical elements such as finite elements, a CAD model allows the storing of a list of features and parameters, which is lighter in terms of storage and memory footprint. Working on CAD models thus reduced memory requirements for the underlying systems, as compared for example to CAE models, in addition to facilitate editability of the model. This amounts to say that a CAE to CAD conversion process in fact compresses the CAE model into a CAD model which is lighter in terms of memory requirements (*e.g*. footprint), in addition to transforming the CAE model into a more easily editable CAD model.

The generation of a custom computer program from CAD files or distributed CAD specifications may be automated. Such generation may therefore be errorproof and may ensure a perfect reproduction of the CAD model to a manufactured product. CNC is considered to provide more precision, complexity and repeatability than is possible with manual machining. Other benefits include greater accuracy, speed and flexibility, as well as capabilities such as contour machining, which allows milling of contoured shapes, including those produced in 3D designs.

The B-rep (i.e. boundary representation) is a 3D representation of a mechanical part. Specifically, the B-rep is a persistent data representation describing the 3D modeled object representing the mechanical part. The B-rep may be the result of computations and/or a series of operations carried out during a designing phase of the 3D modeled object representing the mechanical part. The shape of the mechanical part displayed on the screen of the computer when the modeled object is represented is (e.g. a tessellation of) the B-rep. In examples, the B-rep represents a part of the model object.

A B-Rep includes topological entities and geometrical entities. Topological entities are: face, edge, and vertex. Geometrical entities are 3D objects: surface, plane, curve, line, point. By definition, a face is a bounded portion of a surface, named the supporting surface. An edge is a bounded portion of a curve, named the supporting curve. A vertex is a point in 3D space. They are related to each other as follows. The bounded portion of a curve is defined by two points (the vertices) lying on the curve. The bounded portion of a surface is defined by its boundary, this boundary being a set of edges lying on the surface. The boundary of the edges of the face are connected by sharing vertices. Faces are connected by sharing edges. Two faces are adjacent if they share an edge. Similarly, two edges are adjacent if they share a vertex. In the CAD system, the B-Rep gathers in an appropriate data structure the "is bounded by" relationship, the relationship between topological entities and supporting geometries, and mathematical descriptions of supporting geometries. An internal edge of a B-Rep is an edge shared by exactly two faces. By definition, a boundary edge is not shared, it bounds only one face. By definition, a boundary face is bounded by at least one boundary edge. A B-Rep is said to be closed if all its edges are internal edges. A B-Rep is said to be open is it includes at least one boundary edge. A closed B-Rep is used to model a thick 3D volume because it defines the inside portion of space (virtually) enclosing material. An open B-Rep is used to model a 3D skin, which represents a 3D object the thickness of which is sufficiently small to be ignored.

A key advantage of the B-Rep over any other representation types used in CAD modeling is its ability to represent arbitrary shapes exactly. All other representations in use, such as point clouds, distance fields and meshes, perform an approximation of the shape to represent by discretization. The B-Rep, on the other hand, contains surface equations that represent the exact design and therefore constitutes a true "master model" for further manufacturing, whether this be generation of toolpaths for CNC, or discretizing into the correct sample density for a given 3D Printer technology. In other words, by using a B-Rep, the 3D model may be an exact representation of the manufactured object. The B-Rep is also advantageous for simulating the behavior of a 3D model. In terms of stress, thermal, electromagnetic or other analysis, it supports local refinement of the simulation meshes to capture physical phenomena, and for kinematics it supports true contact modeling between curved surfaces. Finally, a B-Rep allows a small memory and/or file footprint. First, because the representation contains surfaces based only on parameters. In other representations such as meshes, the equivalent surface comprises up to thousands of triangles. Second, because a B-Rep doesn't contain any history-based information.

The method may be included in a production process, which may comprise, after performing the method, producing a physical product corresponding to the modeled object designed/processed/outputted by the method. The production process may comprise the following steps:
- (*e.g*. automatically) applying the method, thereby obtaining the CAD model;
- using the obtained CAD model for manufacturing the part/product.

Using a CAD model for manufacturing designates any real-world action or series of action that is/are involved in/participate to the manufacturing of the product/part represented by the CAD model. Using the CAD model for manufacturing may for example comprise one or more of the following steps:
- editing the obtained CAD model;
- performing simulation(s) based on the CAD model or on a corresponding CAE model (*e*.*g*. the CAE model from which the CAD model stems, after a CAE to CAD conversion process), such as simulations for validation of mechanical, use and/or manufacturing properties and/or constraints (*e.g.* structural simulations, thermodynamics simulation, aerodynamic simulations);
- editing the CAD model based on the results of the simulation(s);
- optionally (*i.e*. depending on the manufacturing process used, the production of the mechanical product may or may not comprise this step), (*e.g.* automatically) determining a manufacturing specifications/CAM specifications (*e.g*. stored as a manufacturing file/CAM file or as distributed CAM data stored on one or more storage (*e.g*. comprising manufacturing instructions for manufacturing the product represented by the CAD model and/or control instructions for the manufacturing process and/or for commanding the manufacturing process or manufacturing tool(s) thereof)) based on the (*e.g*. edited) CAD model (*e.g*. the control instructions stem from the CAD file or distributed CAD data storing the CAD model and/or specifications of the CAD model), for production/manufacturing of the manufacturing product;
- sending the CAD specifications and/or the manufacturing specifications/CAM specifications to a factory in view of manufacturing the product represented by the CAD model; and/or
- (*e.g.* automatically) producing/manufacturing, based on the determined manufacturing specifications/CAM specifications or on the CAD model, the mechanical product originally represented by the model outputted by the method. This may include feeding (*e.g*. automatically) the manufacturing specifications/CAM specifications and/or the CAD specifications to the machine(s) performing the manufacturing process.

This last step of production/manufacturing may be referred to as the manufacturing step or production step. This step manufactures/fabricates the part/product based on the CAD model and/or the CAM specifications, *e.g.* upon the CAD model and/or CAD specifications being fed to one or more manufacturing machine(s) or computer system(s) controlling the machine(s). The manufacturing step may comprise performing any known manufacturing process or series of manufacturing processes, for example one or more additive manufacturing steps, one or more cutting steps (e.g. laser cutting or plasma cutting steps), one or more stamping steps, one or more forging steps, one or more bending steps, one or more deep drawing steps, one or more molding steps, one or more machining steps (e.g. milling steps) and/or one or more punching steps. Because the design method improves the design of a model (CAE or CAD) representing the part/product, the manufacturing and its productivity are also improved.

Editing the CAD model may comprise, by a user (*i.e*. a designer), performing one or more editions of the CAD model, *e.g.* by using a CAD solution. The modifications of the CAD model may include one or more modifications each of a geometry and/or of a parameter of the CAD model. The modifications may include any modification or series of modifications performed on a feature tree of the model (*e.g*. modification of feature parameters and/or specifications) and/or modifications performed on a displayed representation of the CAD model (*e.g*. a B-rep). The modifications are modifications which maintain the technical functionalities of the part/product, *i.e*. the user performs modifications which may affect the geometry and/or parameters of the model but only with the purpose of making the CAD model technically more compliant with the downstream use and/or manufacturing of the part/product. Such modifications may include any modification or series of modification that make the CAD model technically compliant with specifications of the machine(s) used in the downstream manufacturing process. Such modifications may additionally or alternatively include any modification or series of modification that make the CAD model technically compliant with a further use of the product/part once manufactured, such modification or series of modifications being for example based on results of the simulation(s).

The CAM specifications may comprise a manufacturing set up model obtained from the CAD model. The manufacturing set up may comprise all data required for manufacturing the mechanical product (*e.g*. control instructions for controlling the manufacturing process) so that it has a geometry and/or a distribution of material that corresponds to what is captured by the CAD model, possibly up to manufacturing tolerance errors. Determining the production specifications may comprise applying any CAM (Computer-Aided Manufacturing) or CAD-to-CAM solution for (*e.g*. automatically) determining the production specifications from the CAD model (*e.g*. any automated CAD-to-CAM conversion algorithm). Such CAM or CAD-to-CAM solutions may include one or more of the following software solutions, which enable automatic generation of manufacturing instructions and tool paths for a given manufacturing process based on a CAD model of the product to manufacture:
- Fusion 360,
- FreeCAD,
- CATIA,
- SOLIDWORKS,
- The NC Shop Floor programmer of Dassault Systèmes illustrated on https://my.3dexperience.3ds.com/welcome/fr/compass-world/rootroles/nc-shop-floor-programmer,
- The NC Mill-Turn Machine Programmer of Dassault Systèmes illustrated on https://my.3dexperience.3ds.com/welcome/fr/compass-world/rootroles/nc-mill-turn-machine-programmer, and/or
- The Powder Bed Machine Programmer of Dassault Systèmes illustrated on https://my.3dexperience.3ds.com/welcome/fr/compass-world/rootroles/powder-bed-machine-programmer.

The product/part may be an additive manufacturable part, *i.e.* a part to be manufactured by additive manufacturing (*i.e.* 3D printing). In this case, the production process does not comprise the step of determining the CAM specifications and directly proceeds to the producing/manufacturing step, by directly (*e.g.* and automatically) feeding a 3D printer with the CAD model. 3D printers are configured for, upon being fed with a CAD model representing a mechanical product (*e.g*. and upon launching, by a 3D printer operator, the 3D printing), directly and automatically 3D print the mechanical product in accordance with the CAD model. In other words, the 3D printer receive the CAD model, which is (*e.g.* automatically) fed to it, reads (*e.g.* automatically) the CAD model, and prints (*e.g.* automatically) the part by adding together material, *e.g.* layer by layer, to reproduce the geometry and/or distribution of material captured by the CAD model. The 3D printer adds the material to thereby reproduce exactly in reality the geometry and/or distribution of material captured by the CAD model, up to the resolution of the 3D printer, and optionally with or without tolerance errors and/or manufacturing corrections. The manufacturing may comprise, *e.g.* by a user (*e.g.* an operator of the 3D printer) or automatically (by the 3D printer or a computer system controlling it), determining such manufacturing corrections and/or tolerance errors, for example by modifying the CAD specifications to match specifications of the 3D printer. The production process may additionally or alternatively comprise determining (*e.g*. automatically by the 3D printer or a computer system controlling it) from the CAD model, a printing direction, for example to minimize overhang volume (as described in European patent No. 3327593, which is incorporated herein by reference), a layer-slicing (i.e., determining thickness of each layer, and layer-wise paths/trajectories and other characteristics for the 3D printer head (e.g., for a laser beam, for example the path, speed, intensity/temperature, and other parameters).

The product/part may alternatively be a machined part (*i.e.* a part manufactured by machining), such as a milled part (*i.e.* a part manufactured by milling). In such a case, the production process may comprise a step of determining the CAM specifications. This step may be carried out automatically, by any suitable CAM solution to automatically obtain a CAM specifications from a CAD model of a machined part. The determination of the CAM specifications may comprise (*e.g*. automatically) checking if the CAD model has any geometric particularity (*e.g*. error or artefact) that may affect the production process and (*e.g*. automatically) correcting such particularities. For example, machining or milling based on the CAD model may not be carried out if the CAD model still comprises sharp edges (because the machining or milling tool cannot create sharp edges), and in such a case the determination of the CAM specifications may comprise (*e.g.* automatically) rounding or filleting such sharp edges (*e.g.* with a round or fillet radius that corresponds, *e.g.* substantially equals up to a tolerance error, the radius of the cutting head of the machining tool), so that machining or milling based on the CAD model can be done. More generally, the determination of the CAM specifications may automatically comprise rounding or filleting geometries within the CAD model that are incompatible with the radius of the machining or milling tool, to enable machining/milling. This check and possible corrections (*e.g.* rounding or filleting of geometries) may be carried out automatically as previously discussed, but also, by a user (*e.g.* a machining engineer), which performs the correction by hand on a CAD and/or CAM solution, *e.g.* the solution constraining the user to perform corrections that make the CAD model compliant with specifications of the tool used in the machining process.

Further to the check, the determination of the CAM specifications may comprise (*e.g.* automatically) determining the machining or milling path, *i.e.* the path to be taken by the machining tool to machine the product. The path may comprise a set of coordinates and/or a parameterized trajectory to be followed by the machining tool for machining, and determining the path may comprise (*e.g.* automatically) computing these coordinates and/or trajectory based on the CAD model. This computation may be based on the computation of a boundary of a Minkowski subtraction of the CAD model by a CAD model representation of the machining tool, as for example discussed in European Patent Application EP21306754.9 filed on 13 December 2021 by Dassault Systèmes, and which is incorporated herein by reference. It is to be understood that the path may be a single path, *e.g.* that the tool continuously follows without breaking contact with the material to be cut. Alternatively, the path may be a concatenation of a sequence sub-paths to be followed in a certain order by the tool, *e.g.* each being continuously followed by the tool without breaking contact with the material to be cut. Optionally, the determination of the CAM specifications may then comprise (*e.g.* automatically) setting machine parameters, including cutting speed, cut/pierce height, and/or mold opening stroke, for example based on the determined path and on the specification of the machine. Optionally, the determination of the CAM specifications may then comprise (*e.g.* automatically) configuring nesting where the CAM solution decides the best orientation for a part to maximize machining efficiency.

In this case of a machining or milling part, the determining of the CAM specifications thus results in, and outputs, the CAM specifications comprising a machining path, and optionally the set machine parameters and/or specifications of the configured nesting. This outputted CAM specifications may be then (*e.g.* directly and automatically) fed to the machining tool and/or the machining tool may then (*e.g.* directly and automatically) be programmed by reading the specifications, upon which the production process comprises the producing/manufacturing step where the machine performs the machining of the product according to the production specifications, *e.g.* by directly and automatically executing the production specifications. The machining process comprises the machining tool cutting a real-world block of material to reproduce the geometry and/or distribution of material captured by the CAD model, *e.g.* up to a tolerance error (*e.g.* tens of microns for milling).

The product/part may alternatively be a molded part, *i.e.* a part manufactured by molding (*e.g.* injection-molding). In such a case, the production process may comprise the step of determining the CAM specifications. This step may be carried out automatically, by any suitable CAM solution to automatically obtain a CAM specifications from a CAD model of a molded part. The determining of the CAM specifications may comprise (*e.g.* automatically) performing a sequence of molding checks based on the CAD model to check that the geometry and/or distribution of material captured by the CAD model is adapted for molding, and (*e.g.* automatically) performing the appropriate corrections if the CAD model is not adapted for molding. Performing the checks and the appropriate corrections (if any) may be carried out automatically, or, alternatively, by a user (*e.g.* a molding engineer), for example using a CAD and/or CAM solution that allows a user to perform the appropriate corrections on the CAD model but constraints him/her corrections that make the CAD model compliant with specifications of the molding tool(s). The checks may include: verifying that the virtual product as represented by the CAD model is consistent with the dimensions of the mold and/or verifying that the CAD model comprises all the draft angles required for demolding the product, as known *per se* from molding. The determining of the CAM specifications may then further comprise determining, based on the CAD model, a quantity of liquid material to be used for molding, and/or a time to let the liquid material harden/set inside the mold, and outputting CAM specifications comprising these parameters. The production process then comprises (*e.g.* automatically) performing the molding based on the outputted specifications, where the mold shapes, for the determined hardening time, a liquid material into a shape that corresponds to the geometry and/or distribution of material captured by the CAD model, *e.g.* up to a tolerance error (*e.g.* up to the incorporation of draft angles or to the modification of draft angles, for demolding).

The product/part may alternatively be a stamped part, also possibly referred to as "stamping part", *i.e.* a part to be manufactured in a stamping process. The production process may in this case comprise (*e.g.* automatically) determining CAM specifications based on the CAD model. The CAD model represents the stamping part, *e.g.* possible with one or more flanges if the part is to comprise some, and possibly in this latter case with extra material to be removed so as to form an unfolded state of one or more flanges of the part, as known *per se* from stamping. The CAD model thus comprises a portion that represents the part without the flanges (which is the whole part in some cases) and possibly an outer extra patch portion that represents the flanges (if any), with possibly the extra material (if any). This extra patch portion may present a g2-continuity over a certain length and then a g1-continuity over a certain length.

The determination of the CAM specifications may in this stamping case comprise (*e.g.* automatically) determining parameters of the stamping machine, for example a size of a stamping die or punch and/or a stamping force, based on the geometry and/or distribution of material of the virtual product as captured by the CAD model. If the CAD model also comprises the representation of the extra material to be removed so as to form an unfolded state of one or more flanges of the part, the extra material to be removed may for example be cut by machining, and determining the CAM specifications may also comprise determining a corresponding machining CAM specifications, *e.g.* as discussed previously. If there are one or more flanges, determining the CAM specifications may comprise determining geometrical specifications of the g2-continuity and g1-continuity portions that allow, after the stamping itself and the removal of the extra material, to fold in a folding process the flanges towards an inner surface of the stamped part and along the g2-continuity length. The CAM specifications thereby determined may thus comprise: parameters of the stamping tool, optionally said specifications for folding the flanges (if any), and optionally a machining production specifications for removing the extra material (if any).

The stamping production process may then output, *e.g.* directly and automatically, the CAM specifications, and perform the stamping process (*e.g.* automatically) based on the specifications. The stamping process may comprise stamping (*e.g.* punching) a portion of material to form the product as represented by the CAD specifications, that is possibly with the unfolded flanges and the extra material (if any). Where appropriate, the stamping process may then comprise cutting the extra material based on the machining production specifications and folding the flanges based on said specifications for folding the flanges, thereby folding the flanges on their g2-continuity length and giving a smooth aspect to the outer boundary of the part. In this latter case, the shape of the part once manufactured differ from its virtual counterpart as represented by the CAD model in that the extra material is removed and the flanges are folded, whereas the CAD model represents the part with the extra material and the flanges in an unfolded state.

The method is computer-implemented. This means that steps (or substantially all the steps) of the method are executed by at least one computer, or any system alike. Thus, steps of the method are performed by the computer, possibly fully automatically, or, semi-automatically. In examples, the triggering of at least some of the steps of the method may be performed through user-computer interaction. The level of user-computer interaction required may depend on the level of automatism foreseen and put in balance with the need to implement user's wishes. In examples, this level may be user-defined and/or pre-defined.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g. one for the program, and possibly one for the database).

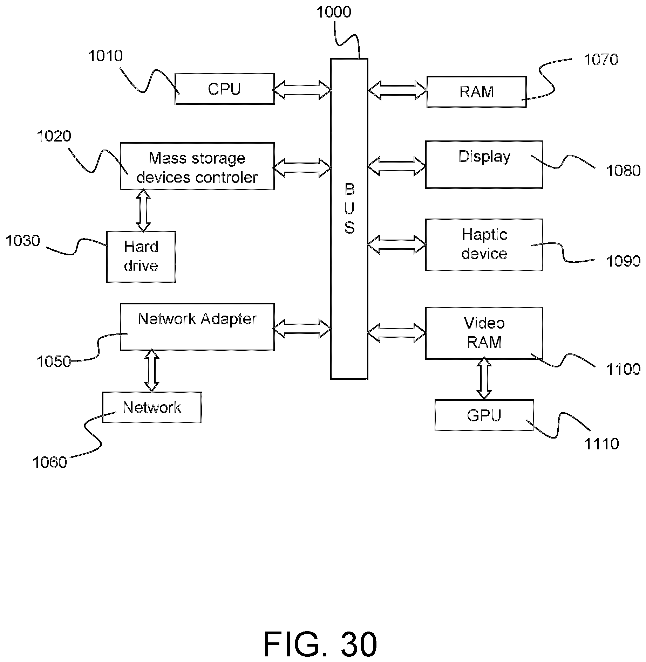

FIG. 30 shows an example of the system, wherein the system is a client computer system, e.g. a workstation of a user.

The client computer of the example comprises a central processing unit (CPU) 1010 connected to an internal communication BUS 1000, a random access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

## Claims

1. A computer-implemented method for machine-learning a classification function configured for detection of mechanical interfaces of a CAD model, the CAD model representing a single mechanical part, the method comprising:
- obtaining a training dataset comprising training samples, each training sample comprising a graph representing a CAD model representing a single mechanical part, the graph comprising:
• one or more nodes, each node representing a canonical surface of the CAD model; each node comprising a label which is one within the label list:
∘ primary face of a mechanical interface;
∘ secondary face of a mechanical interface;
∘ tertiary face of a mechanical interface;
∘ maintain face of a mechanical interface; and
∘ no interface; and
• one or more edges, each edge representing a connection between the canonical surfaces represented by the nodes connected by the edge; and
- training the classification function based on the training dataset to classify, with a label of the label list, each node of a graph representing a CAD model representing a single mechanical part.

2. The method of claim 1, wherein each of the graphs comprised in the training dataset comprises:
• a node-vector for each node, the node-vector being a feature vector representing properties of the canonical surface represented by the node; and/or
• an edge-vector for each edge, the edge-vector being a feature vector representing properties of the connection represented by the edge.

3. The method of claim 2, wherein:
• the properties of the canonical surface represented by each node-vector comprise: surface type, area, radius, orientation, material, or a combination thereof; and/or
• the properties of the connection represented by each edge-vector comprise: convexity, concavity, coplanarity, coaxiality, neighbor smooth, presence of a fillet, presence of a chamfer, presence of a connection other than a fillet or a chamfer, or a combination thereof.

4. The method of any one of claims 1 to 3, wherein obtaining the training dataset comprises:
• obtaining a first dataset comprising CAD models representing mechanical objects;
• extracting from the first dataset a second dataset comprising CAD models representing single mechanical parts; and
• for each CAD model in the second dataset determining a graph representing the CAD model.

5. The method of claim 4, wherein the determining of the graph representing the CAD model comprises:
• determining the canonical surfaces of the CAD model, and generating a node for each determined canonical surface; and
• determining the connections between couples of canonical surfaces of the CAD model, and generating an edge for each couple of connected canonical surfaces.

6. The method of any one of claims 1 to 5, wherein each canonical surface is a portion of a plane, of a sphere, of a cone, of a torus, or of a cylinder.

7. The method of any one of claims 1 to 6, wherein the classification function comprises a graph neural network.

8. The method of any one of claims 1 to 7, wherein training the classification function comprises sampling nodes of each of the graphs in the training dataset so as to balance the no interface labels with the other labels.

9. The method of any one of claims 1 to 8, wherein the classification function further comprises a module configured to form mechanical interfaces based on the outputted labels by regrouping neighboring canonical surfaces corresponding to primary, secondary, tertiary, and maintain faces.

10. A machine-learnt classification function obtainable according to any one of claims 1 to 9.

11. A computer-implemented method of use of the machine-learnt classification function of claim 10, the method of use comprising:
- obtaining a CAD model representing a single mechanical part;
- determining a graph representing the CAD model, the graph comprising:
• one or more nodes, each node representing a canonical surface of the CAD model; and
• one or more edges, each edge representing a connection between the canonical surfaces represented by the nodes connected by the edge; and
- applying the machine-learnt classification function to the graph.

12. A computer-program comprising instructions which, when the program is executed on a computer, cause the computer to carry out the method of any one of claims 1 to 9, and/or the method of claim 11.

13. A computer-readable storage medium having recorded thereon the computer-program of claim 12 and/or the machine-learnt classification function of claim 10.

14. A system comprising a processor coupled to a memory, the memory having recorded thereon the computer-program of claim 12 and/or the machine-learnt classification function of claim 10.

## Amended claims

### Amended claims in accordance with Rule 137(2) EPC.

**1.** A computer-implemented method for machine-learning and of use of a classification function configured for detection of mechanical interfaces of a CAD model, the CAD model representing a single mechanical part, the method comprising:
- obtaining a training dataset comprising training samples, each training sample comprising a graph representing a CAD model representing a single mechanical part, the graph comprising:
• one or more nodes, each node representing a canonical surface of the CAD model; each node comprising a label which is one within the label list:
∘ primary face of a mechanical interface, the primary face being a canonical surface that reduces the most degrees of freedom in an assembly of mechanical parts comprising the single mechanical part;
∘ secondary face of a mechanical interface, the secondary face being a canonical surface that is not a primary face and that reduces the most degrees of freedom in an assembly of mechanical parts comprising the single mechanical part, aside from the primary faces;
∘ tertiary face of a mechanical interface, the tertiary face being a canonical surface that is neither a primary face nor a secondary face and that reduces at least a degree of freedom in an assembly of mechanical parts comprising the single mechanical part;
∘ maintain face of a mechanical interface, the maintain face being a canonical surface that maintains the mechanical parts in the position set by the primary, secondary and tertiary surfaces within an assembly of mechanical parts comprising the single mechanical part; and
∘ no interface; and
• one or more edges, each edge representing a connection between the canonical surfaces represented by the nodes connected by the edge; and
- training the classification function based on the training dataset to classify, with a label of the label list, each node of a graph representing a CAD model representing a single mechanical part;
- obtaining a CAD model representing a single mechanical part;
- determining a graph representing the CAD model, the graph comprising:
• one or more nodes, each node representing a canonical surface of the CAD model; and
• one or more edges, each edge representing a connection between the canonical surfaces represented by the nodes connected by the edge;
- applying the machine-learnt classification function to the graph, thereby detecting mechanical interfaces of the obtained CAD model; and
- using the detected mechanical interfaces to manufacture the single mechanical part;
wherein the classification function further comprises a module configured to form mechanical interfaces based on the outputted labels by regrouping neighboring canonical surfaces corresponding to primary, secondary, tertiary, and maintain faces.

**2.** The method of claim 1, wherein each of the graphs comprised in the training dataset comprises:
• a node-vector for each node, the node-vector being a feature vector representing properties of the canonical surface represented by the node; and/or
• an edge-vector for each edge, the edge-vector being a feature vector representing properties of the connection represented by the edge.

**3.** The method of claim 2, wherein:
• the properties of the canonical surface represented by each node-vector comprise: surface type, area, radius, orientation, material, or a combination thereof; and/or
• the properties of the connection represented by each edge-vector comprise: convexity, concavity, coplanarity, coaxiality, neighbor smooth, presence of a fillet, presence of a chamfer, presence of a connection other than a fillet or a chamfer, or a combination thereof.

**4.** The method of any one of claims 1 to 3, wherein obtaining the training dataset comprises:
• obtaining a first dataset comprising CAD models representing mechanical objects;
• extracting from the first dataset a second dataset comprising CAD models representing single mechanical parts; and
• for each CAD model in the second dataset determining a graph representing the CAD model.

**5.** The method of claim 4, wherein the determining of the graph representing the CAD model comprises:
• determining the canonical surfaces of the CAD model, and generating a node for each determined canonical surface; and
• determining the connections between couples of canonical surfaces of the CAD model, and generating an edge for each couple of connected canonical surfaces.

**6.** The method of any one of claims 1 to 5, wherein each canonical surface is a portion of a plane, of a sphere, of a cone, of a torus, or of a cylinder.

**7.** The method of any one of claims 1 to 6, wherein the classification function comprises a graph neural network.

**8.** The method of any one of claims 1 to 7, wherein training the classification function comprises sampling nodes of each of the graphs in the training dataset, the sampling of the nodes comprising, at each batch and epoch during the training of the classification function, computing the loss function with respect to all the nodes with an interface and a proportion of the nodes with no interface, the proportion being so that a same proportion of nodes are considered in the loss function with an interface and a no interface.

**9.** A computer-program comprising instructions which, when the program is executed on a computer, cause the computer to carry out the method of any one of claims 1 to 8.

**10.** A computer-readable storage medium having recorded thereon the computer-program of claim 9.

**11.** A system comprising a processor coupled to a memory, the memory having recorded thereon the computer-program of claim 9.

**1.** A computer-implemented method for machine-learning and of use of a classification function configured for detection of mechanical interfaces of a CAD model, the CAD model representing a single mechanical part, the method comprising:
- obtaining a training dataset comprising training samples, each training sample comprising a graph representing a CAD model representing a single mechanical part, the graph comprising:
• one or more nodes, each node representing a canonical surface of the CAD model; each node comprising a label which is one within the label list:
∘ primary face of a mechanical interface, the primary face being a canonical surface that reduces the most degrees of freedom in an assembly of mechanical parts comprising the single mechanical part;
∘ secondary face of a mechanical interface, the secondary face being a canonical surface that is not a primary face and that reduces the most degrees of freedom in an assembly of mechanical parts comprising the single mechanical part, aside from the primary faces;
∘ tertiary face of a mechanical interface, the tertiary face being a canonical surface that is neither a primary face nor a secondary face and that reduces at least a degree of freedom in an assembly of mechanical parts comprising the single mechanical part;
∘ maintain face of a mechanical interface, the maintain face being a canonical surface that maintains the mechanical parts in the position set by the primary, secondary and tertiary surfaces within an assembly of mechanical parts comprising the single mechanical part; and
∘ no interface; and
• one or more edges, each edge representing a connection between the canonical surfaces represented by the nodes connected by the edge; and
- training the classification function based on the training dataset to classify, with a label of the label list, each node of a graph representing a CAD model representing a single mechanical part;
- obtaining a CAD model representing a single mechanical part;
- determining a graph representing the CAD model, the graph comprising:
• one or more nodes, each node representing a canonical surface of the CAD model; and
• one or more edges, each edge representing a connection between the canonical surfaces represented by the nodes connected by the edge;
- applying the machine-learnt classification function to the graph, thereby detecting mechanical interfaces of the obtained CAD model; and
- using the detected mechanical interfaces to manufacture the single mechanical part, zones of interaction represented by the mechanical interfaces being manufactured with a higher precision and more detailed tolerances than other zones of the single mechanical part that are not supposed to have functional roles or be in contact with other mechanical parts;
wherein the classification function further comprises a module configured to form mechanical interfaces based on the outputted labels by regrouping neighboring canonical surfaces corresponding to primary, secondary, tertiary, and maintain faces.

**2.** The method of claim 1, wherein each of the graphs comprised in the training dataset comprises:
• a node-vector for each node, the node-vector being a feature vector representing properties of the canonical surface represented by the node; and/or
• an edge-vector for each edge, the edge-vector being a feature vector representing properties of the connection represented by the edge.

**3.** The method of claim 2, wherein:
• the properties of the canonical surface represented by each node-vector comprise: surface type, area, radius, orientation, material, or a combination thereof; and/or
• the properties of the connection represented by each edge-vector comprise: convexity, concavity, coplanarity, coaxiality, neighbor smooth, presence of a fillet, presence of a chamfer, presence of a connection other than a fillet or a chamfer, or a combination thereof.

**4.** The method of any one of claims 1 to 3, wherein obtaining the training dataset comprises:
• obtaining a first dataset comprising CAD models representing mechanical objects;
• extracting from the first dataset a second dataset comprising CAD models representing single mechanical parts; and
• for each CAD model in the second dataset determining a graph representing the CAD model.

**5.** The method of claim 4, wherein the determining of the graph representing the CAD model comprises:
• determining the canonical surfaces of the CAD model, and generating a node for each determined canonical surface; and
• determining the connections between couples of canonical surfaces of the CAD model, and generating an edge for each couple of connected canonical surfaces.

**6.** The method of any one of claims 1 to 5, wherein each canonical surface is a portion of a plane, of a sphere, of a cone, of a torus, or of a cylinder.

**7.** The method of any one of claims 1 to 6, wherein the classification function comprises a graph neural network.

**8.** The method of any one of claims 1 to 7, wherein training the classification function comprises sampling nodes of each of the graphs in the training dataset, the sampling of the nodes comprising, at each batch and epoch during the training of the classification function, computing the loss function with respect to all the nodes with an interface and a proportion of the nodes with no interface, the proportion being so that a same proportion of nodes are considered in the loss function with an interface and a no interface.

**9.** A computer-program comprising instructions which, when the program is executed on a computer, cause the computer to carry out the method of any one of claims 1 to 8.

**10.** A computer-readable storage medium having recorded thereon the computer-program of claim 9.

**11.** A system comprising a processor coupled to a memory, the memory having recorded thereon the computer-program of claim 9.
